# EUROPEAN PATENT SPECIFICATION

(11) **EP 4 346 193 B1**
(45) Date of publication and mention of the grant of the patent: **24.09.2025**
(21) Application number: 23750523.5
(22) Date of filing: 10.07.2023
(51) Int. Cl.: G06F 1/16, H04M 1/02, H04M 1/18, G06F 3/041, H05K 5/06, H05K 9/00, H10K 59/80

(54) **DISPLAY MODULE AND ELECTRONIC DEVICE COMPRISING DISPLAY MODULE**
ANZEIGEMODUL UND ELEKTRONISCHE VORRICHTUNG DAMIT
MODULE D'AFFICHAGE ET DISPOSITIF ÉLECTRONIQUE COMPRENANT LE MODULE D'AFFICHAGE

(30) Priority: 04.08.2022 KR 20220097369; 10.08.2022 KR 20220100187
(43) Date of publication of application: 03.04.2024
(73) Proprietor: Samsung Electronics Co., Ltd., Suwon-si, Gyeonggi-do 16677 (KR)
(72) Inventor: AN, Jungchul, Suwon-si, Gyeonggi-do 16677 (KR); KIM, Sangkyu, Suwon-si, Gyeonggi-do 16677 (KR)
(74) Representative: HGF
(86) International application number: PCT/KR2023/009780
(87) International publication number: WO 2024/029766

(56) References cited:
- EP-A1- 4 344 372
- KR-A- 20200 021 172
- KR-A- 20200 057 236
- KR-A- 20210 047 753
- KR-A- 20210 070 880
- US-A1- 2019 005 857
- US-A1- 2022 137 667

## Description

### [Technical Field]

Various embodiments disclosed herein relate to a display module and an electronic device including the same, and to a structure of a light-weight display module.

### [Background Art]

As an amount of information which is displayed visually increases and electronic devices support more functions, a number of users who want a large-screen display is increasing. New types of electronic device are being developed to provide a large-screen display while maintaining a portable size.

With the development of display technology, a foldable display can be implemented. An electronic device in which an area for displaying information is variable by folding using such a display is also being released.

Electronic devices may support various types of pen input devices. An electronic device may include a display module including a separate element (e.g., a digitizer) for recognizing an input of a pen input device.

With increase in weight of a display due to the arrangement of various elements in the display module, it is preferable to reduce the weight of the display module.

EP 4 344 372 A1 (cited under Article 54(3) EPC) discloses, according to its abstract, an electronic device including a digitizer panel including a first digitizer panel and a second digitizer panel, a first shielding member which includes a (1-1)st shielding member disposed on the first digitizer panel and a (1-2)nd shielding member disposed on the second digitizer panel, the first shielding member being disposed on the rear surface of the digitizer panel, a reinforced plate disposed on the rear surface of the first shielding member, a second shielding member including a (2-1)st shielding member, at least a part of which is disposed on the rear surface of the (1-1)st shielding member , a (2-2)nd shielding member disposed on the rear surface of the first reinforced plate, and a (2-3)rd shielding member, at least a part of which is disposed on the rear surface of the (1-2)nd shielding member, and a waterproof structure including a first waterproof member, at least a part of which is disposed on the rear surface of the reinforced plate to be disposed between the (2-1)st shielding member and the (2-2)nd shielding member, and a second waterproof member, at least a part of which is disposed on the rear surface of the reinforced plate.

US 2022/137667 A1 discloses, according to its abstract, an electronic device including a first housing with a first support member, a second housing foldably coupled to the first housing through a hinge mechanism and including a second support member, a flexible display supported by the first housing and the second housing, the flexible display including: a window layer, a display panel disposed under the window layer, and a bending portion extended from the display panel and attached to a rear surface of the display panel, the bending portion including: an extension portion and a control circuit and a flexible substrate, a first waterproof member, a second waterproof member, and a third waterproof member that connects the first waterproof member and second waterproof member, wherein when the flexible display is viewed from above, the control circuit and the flexible substrate overlap a first waterproof space formed through the first, second and third waterproof member.

### [Disclosure of Invention]

### [Technical Problem]

The foldable display module may include a bendable display panel in order to implement a folding operation. A plate (e.g., a reinforced plate) having a predetermined level of rigidity and supporting a display panel may be disposed in the display module so that durability of the display module can be secured. In addition, with the development of display implementation technology, various elements can be disposed in the display module. For example, a digitizer for recognizing an input from a pen input device may be included in the display module.

As described above, with the increase in weight of a display due to inclusion of various elements in the display module, it may be required to reduce the weight of the display module. In order to reduce the weight of the display module, reducing the weight of a reinforced plate supporting the display panel may be considered. In order to reduce the weight of the reinforced plate, reducing the thickness of the reinforced plate or changing the material of the reinforced plate may be considered. When the thickness of the reinforced plate is reduced, the durability of the reinforced plate may decrease. In addition, when the material of the reinforced plate is changed, the corrosion resistance of the reinforced plate may decrease.

According to an embodiment of the disclosure, a reinforced plate having a reduced weight may be provided and the durability and corrosion resistance of the reinforced plate may be secured, or achieved, at a predetermined level.

### [Solution to Problem]

The scope of the present invention is determined according to the independent claim. Various embodiments of the present invention are outlined in the dependent claims.

Also disclosed herein is an electronic device including a first housing, a second housing rotatably connected to the first housing, and a display module including a folding area at least partially deformed by rotation of the second housing relative to the first housing, wherein the display module includes a display panel, a support plate disposed under the display panel to support the display panel, a reinforced plate disposed under the support plate, a protective layer disposed under the reinforced plate and including multiple openings, and a waterproof member disposed under the protective layer to have a waterproof space including at least one of the multiple openings.

Also disclosed herein is a display module disposed in a first housing and a second housing rotatably coupled to each other may include a display panel, a support plate disposed under the display panel to support the display panel and including multiple patterns positioned in a folding area of the display module, a reinforced plate disposed under the support plate, a protective layer disposed under the reinforced plate and including multiple openings, and a waterproof member disposed under the protective layer to have a waterproof space including at least one of the multiple openings.

### [Advantageous Effects of Invention]

According to an embodiment of the disclosure, the weight of the reinforced plate may be reduced by changing the thickness and/or material of the reinforced plate supporting the display panel. the durability and corrosion resistance of the reinforced plate may be improved by disposing a protective layer (e.g., an insulating layer) on the reinforced plate.

### [Brief Description of Drawings]

In describing the drawings, identical or similar reference numerals may be used for identical or similar elements.
FIGS. 1A and 1B illustrate an electronic device according to an embodiment of the disclosure, which is in an unfolded state and viewed from front and rear.
FIGS. 2A and 2B illustrate an electronic device according to an embodiment of the disclosure, which is in a folded state and viewed from front and rear.
FIG. 3 is an exploded perspective diagram of an electronic device according to an embodiment of the disclosure.
FIG. 4 is an exploded perspective diagram of a first display according to an embodiment of the disclosure.
FIG. 5 illustrates the configuration of reinforced plates according to an embodiment of the disclosure.
FIG. 6 illustrates a rear structure of a display module according to an embodiment of the disclosure.
FIG. 7 is a diagram obtained by cutting the display module illustrated in FIG. 6 according to an embodiment of the disclosure along line B-B and schematizing cross-sections of the display module and peripheral elements thereof.
FIG. 8 illustrates a state in which a protective layer is disposed on the rear surface of the display module in FIG. 6 according to an embodiment of the disclosure.
FIG. 9A is a schematic diagram of a cross-section of the display module illustrated in FIG. 8 according to an embodiment of the disclosure and cut along line C-C.
FIG. 9B is a cross -sectional diagram of the display module illustrated in FIG. 8 according to an embodiment of the disclosure without a digitizer panel.
FIG. 10A illustrates a cross-sectional diagram in which a non-conductive member is disposed in a second opening of a protective layer illustrated in FIG. 9A according to an embodiment of the disclosure.
FIG. 10B illustrates a cross-sectional diagram of the display module illustrated in FIG. 9A according to an embodiment of the disclosure without a digitizer panel.

### [Mode for the Invention]

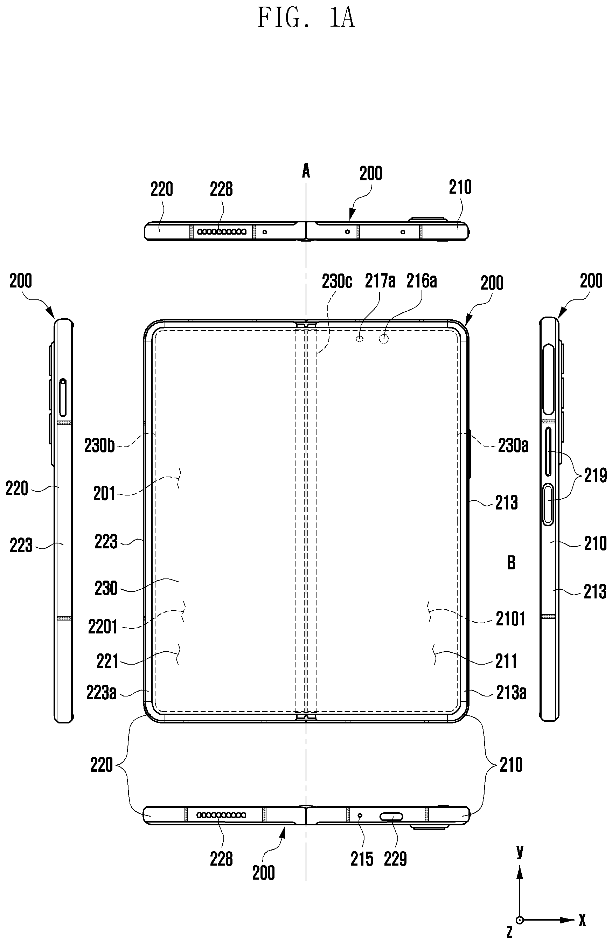

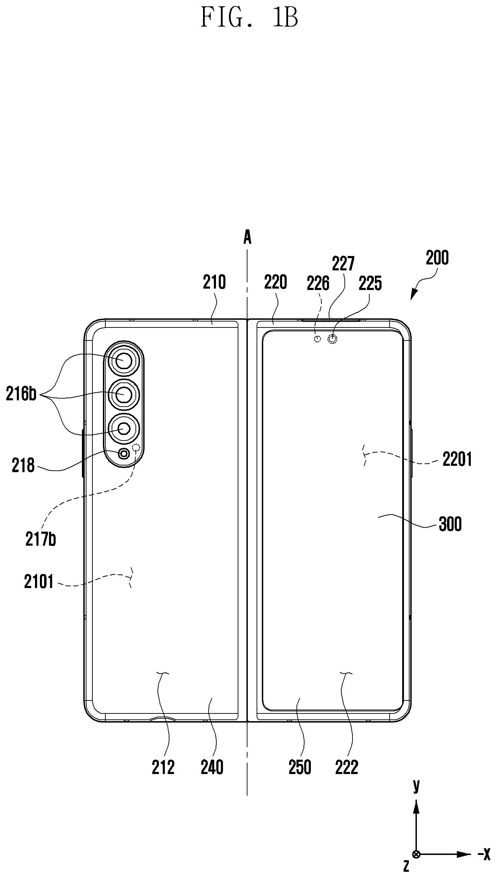

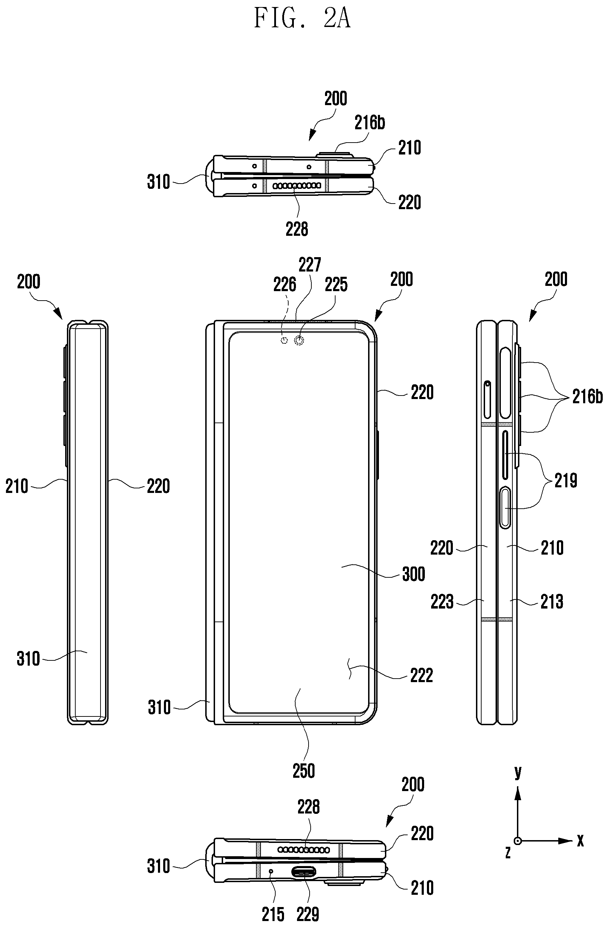

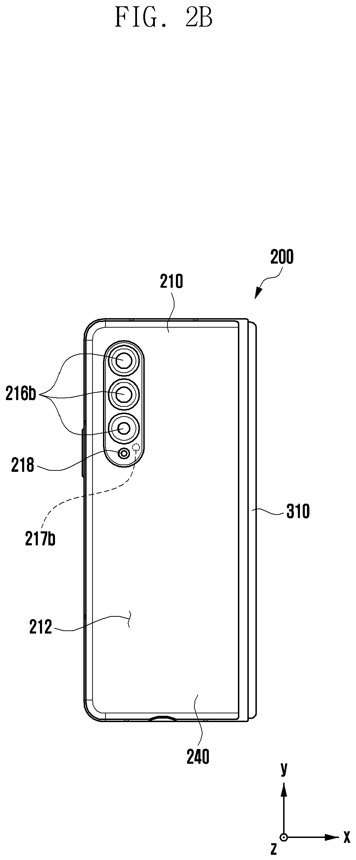

FIGS. 1A and 1B illustrate a front view and a rear view of an unfolded state of an electronic device according to an embodiment of the disclosure. FIGS. 2A and 2B illustrate a front view and a rear view of a folded state of an electronic device according to an embodiment of the disclosure. It is noted that, although the embodiments described below typically refer to an electronic device of a foldable type and/or a display of a foldable type (e.g., display module with a foldable area), the present disclosure is not limited thereto. It will be appreciated that embodiments of the present disclosure also relate to and/or include a generic type of electronic device (e.g., which may be rigid, flexible, foldable, extendable etc.) and generic type of display module (e.g., which may be rigid, flexible, foldable, extendable etc.), where features disclosed herein may be applicable to such a generic type of electronic device and/or display module (unless specifically requiring a foldable device, such as a hinge feature may).

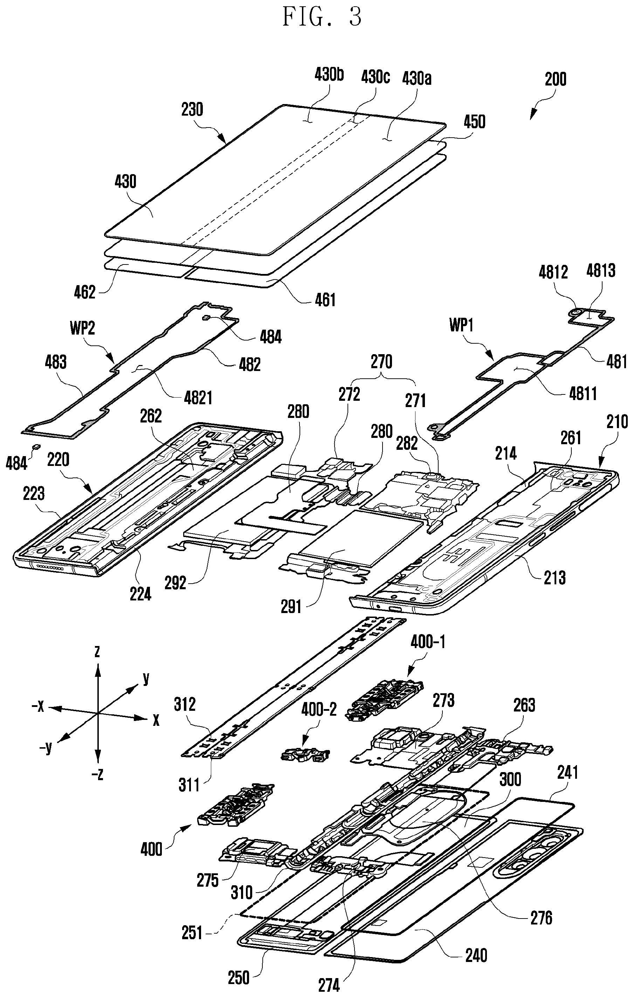

Referring to FIGS. 1A to 2B, an electronic device 200 may include a pair of housings 210 and 220 (e.g., a foldable housing structure) rotatably coupled to each other with reference to folding axis A through a hinge device, a flexible portion or a foldable region (e.g., a hinge device 400, 400-1 of FIG. 3) (e.g., a hinge module) so as to be folded with respect to each other, a first display 230 (e.g., a flexible display, a foldable display, a flexible display area, or a main display) disposed through the pair of housings 210 and 220, and/or a second display 300 (e.g., a sub display a second display area) disposed through the second housing 220. According to an embodiment, at least a part of the hinge device (e.g., the hinge device 400, 400-1 of FIG. 3) may be disposed so as not to be seen or visible from the outside (e.g. externally) through the first housing 210 and the second housing 220, and may be disposed so as not to be seen or visible from the outside (e.g. externally) through the hinge housing 310 covering a foldable portion. In the disclosure, a surface in which the first display 230 is disposed may be defined as a front surface of the electronic device 200, and a surface opposite to the front surface may be defined as a rear surface of the electronic device 200. In addition, a surface surrounding a space between the front surface and the rear surface may be defined as a side surface of the electronic device 200.

According to an embodiment, the pair of housings 210 and 220 may include a first housing 210 (or first portion, first part, first housing portion etc.) and a second housing 220 (or second portion, second part, second housing portion etc.) foldably arranged with respect to each other through/via the hinge device (e.g., the hinge device 400, 400-1 of FIG. 3). According to an embodiment, the shape and the coupling of the pair of housings 210 and 220 are not limited to those illustrated in FIGS. 1A to 2B, and the pair of housings 210 and 220 may be implemented by a combination and/or coupling of other shapes or components. According to an embodiment, the first housing 210 and the second housing 220 may be arranged on opposite sides with reference to the folding axis A, and may have shapes that are entirely or substantially symmetric to each other with respect to the folding axis A. According to an embodiment, the first housing 210 and the second housing 220 may be asymmetrically folded with reference to the folding axis A. According to an embodiment, the angle and/or the distance between the first housing 210 and the second housing 220 may vary depending on whether the electronic device 200 is in an unfolded state, a folded state, or an intermediate state.

According to an embodiment, the first housing 210 may include, in the unfolded state of the electronic device 200, a first surface 211 connected to the hinge device (e.g., the hinge device 400, 400-1 of FIG. 3) and disposed to be oriented to the front surface of the electronic device 200, a second surface 212 oriented in a direction opposite to the first surface 211, and/or a first side member 213 surrounding at least a part of a first space between the first surface 211 and the second surface 212. According to an embodiment, the second housing 220 may include, in the unfolded state of the electronic device 200, a third surface 221 connected to the hinge device (e.g., the hinge device 400, 400-1 of FIG. 3) and disposed to be oriented to the front surface of the electronic device 200, a fourth surface 222 oriented in a direction opposite to the third surface 221, and/or a second side member 223 surrounding at least a part of a second space between the third surface 221 and the fourth surface 222. According to an embodiment, the first surface 211 and the third surface 221 may be oriented in substantially the same direction in the unfolded state, and the first surface 211 and the third surface 221 may at least partially face each other in the folded state. According to an embodiment, the electronic device 200 may include a recess 201 formed to receive the first display 230 through structural coupling of the first housing 210 and the second housing 220. According to an embodiment, the recess 201 may have substantially the same shape as the first display 230.

According to an embodiment, the hinge housing 310 (e.g., a hinge cover, or exterior hinge part) may be disposed between the first housing 210 and the second housing 220, and may be disposed to cover a part (e.g., at least one hinge module) of the hinge device (e.g., the hinge device 400, 400-1 of FIG. 3) disposed on the hinge housing 310. According to an embodiment, the hinge housing 310 may be hidden from or exposed to the outside by a part of the first housing 210 and the second housing 220 according to the unfolded state, the folded state, or the intermediate state of the electronic device 200. For example, when the electronic device 200 is in the unfolded state, at least a part of the hinge housing 310 may be covered by the first housing 210 and the second housing 220 and not be substantially exposed. According to an embodiment, when the electronic device 200 is in the folded state, at least a part of the hinge housing 310 may be exposed to the outside between the first housing 210 and the second housing 220. According to an embodiment, in the intermediate state in which the first housing 210 and the second housing 220 are folded with each other by a predetermined angle (folded with a certain angle), the hinge housing 310 may be at least partially exposed to the outside of the electronic device 200 between the first housing 210 and the second housing 220. For example, in a case of the electronic device being in the intermediate state, an area in which the hinge housing 310 is exposed to the outside may be smaller than that in a case in which the electronic device 200 is completely folded. According to an embodiment, the hinge housing 310 may include a curved surface.

According to an embodiment, when the electronic device 200 is in the unfolded state (e.g., the states shown in FIGS. 1A and 1B), the first housing 210 and the second housing 220 may meet at an about 180-degree angle, and a first area 230a, a second area 230b, and a folding area 230c of the first display 230 may form the same plane and arranged to be oriented in substantially the same direction (e.g., a z-axis direction). In another embodiment, when the electronic device 200 is in the unfolded state, the first housing 210 may rotate by an about 360-degree angle with respect to the second housing 220, and may be outwardly folded (an out-folding scheme) so that the second surface 212 and the fourth surface 222 face each other.

According to an embodiment, when the electronic device 200 is in the folded state (e.g., the states shown in FIGS. 2A and 2B), the first surface 211 of the first housing 210 and the third surface 221 of the second housing 220 may be arranged to face each other. In this case, the first area 230a and the second area 230b of the first display 230 may form a narrow angle (e.g., a range between 0 degree to about 10 degrees) through the folding area 230c, and may be arranged to face each other. According to an embodiment, at least a part of the folding area 230c may be deformed into a curved shape having a predetermined curvature. According to an embodiment, when the electronic device 200 is in the intermediate state, the first housing 210 and the second housing 220 may be arranged at a predetermined angle (a certain angle). In this case, the first area 230a and the second area 230b of the first display 230 may form an angle that is greater than that in the folded state and smaller than that in the unfolded state, and the curvature of the folding area 230c may be lower than that in the folded state, and may be higher than that in the unfolded state. In an embodiment, the first housing 210 and the second housing 220 may form an angle which allows stopping at a designated folding angle between the folded state and the unfolded state (a free stop function), through the hinge device (e.g., the hinge device 400, 400-1 of FIG. 3). In an embodiment, the first housing 210 and the second housing 220 may continuously operate while being pressed in an unfolding direction or a folding direction with reference to a designated inflection angle, through the hinge device (e.g., the hinge device 400, 400-1 of FIG. 3).

According to an embodiment, the electronic device 200 may include at least one of: at least one display 230 and 300 disposed on the first housing 210 and/or the second housing 220, an input device 215, sound output devices 227 and 228, sensor modules 217a, 217b, and 226, camera modules 216a, 216b, and 225, a key input device 219, an indicator (not shown), or a connector port 229. In an embodiment, the electronic device 200 may omit at least one of the elements, or may additionally include at least one another element.

According to an embodiment, the at least one display 230 and 300 may include a first display 230 (e.g., a flexible display) disposed to be supported by the third surface 221 of the second housing 220 from the first surface 211 of the first housing 210 through the hinge device (e.g., the hinge device 400, 400-1 of FIG. 3), and a second display 300 disposed to be at least partially seen from the outside through the fourth surface 222 in a space in the second housing 220. In an embodiment, the second display 300 may be disposed to be seen from the outside through the second surface 212 in a space in the first housing 210. According to an embodiment, the first display 230 may be mainly used in the unfolded state of the electronic device 200, and the second display 300 may be mainly used in the folded state of the electronic device 200. According to an embodiment, the electronic device 200 may control, in the intermediate state, the first display 230 and/or the second display 300 to be used, based on a folding angle between the first housing 210 and the second housing 220.

According to an embodiment, the first display 230 may be disposed in a receiving space (or first accommodation portion) formed by the pair of housings 210 and 220. For example, the first display 200 may be disposed in a recess 201 formed by the pair of housings 210 and 220, and may be disposed to occupy the majority (e.g., substantially all) of the front surface of the electronic device 200 in the unfolded state. According to an embodiment, the first display 230 may include a display module (230) having at least one area which can be deformed into a plane or a curved surface. According to an embodiment, the first display 230 may include the first area 230a facing the first housing 210 and the second area 230b facing the second housing 220. According to an embodiment, the first display 230 may include the folding area 230c including a part of the first area 230a and a part of the second area 230b with respect to the folding axis A. According to an embodiment, at least a part of the folding area 230c may include an area corresponding to the hinge device (e.g., the hinge device 400, 400-1 of FIG. 3). According to an embodiment, a division of an area of the first display 230 merely corresponds to exemplary physical division by the pair of housings 210 and 220 and the hinge device (e.g., the hinge device 400, 400-1 of FIG. 3), and the first display 230 may be substantially displayed as one seamless full screen through the pair of the housings 210 and 220 and the hinge device (e.g., the hinge device 400, 400-1 of FIG. 3). According to an embodiment, the first area 230a and the second area 230b may have shapes that are entirely symmetric or partially asymmetric to each other with respect to the folding area 230c.

According to an embodiment, the electronic device 200 may include a first rear cover 240 disposed on the second surface 212 of the first housing 210 and a second rear cover 250 disposed on the fourth surface 222 of the second housing 220. In an embodiment, at least a part of the first rear cover 240 may be integrally formed with the first side member 213. In an embodiment, at least a part of the second rear cover 250 may be integrally formed with the second side member 223. According to an embodiment, at least one of the first rear cover 240 and the second rear cover 250 may be substantially formed of a transparent plate (e.g., a polymer plate or glass plate including various coding layers) or an opaque plate. According to an embodiment, the first rear cover 240 may be formed of, for example, an opaque plate such as coded or colored glass, ceramic, polymer, metal (e.g., aluminum, stainless steel (STS), or magnesium), or a combination of at least two of the materials above. According to an embodiment, the second rear cover 250 may be substantially formed of, for example, a transparent plate such as glass or polymer. Accordingly, the second display 300 may be disposed to be seen from the outside through the second rear cover 250 in a space in the second housing 220.

According to an embodiment, the input device 215 may include a microphone. In an embodiment, the input device 215 may include multiple microphones arranged to detect the direction of sound. According to an embodiment, the one or more sound output devices 227 and 228 may include speakers. According to an embodiment, the sound output devices 227 and 228 may include a call receiver 227 disposed through the fourth surface 222 of the second housing 220 and an external speaker 228 disposed through at least a part of the second side member 223 of the second housing 220. In an embodiment, the input device 215, the sound output devices 227 and 228, and the connector 229 may be disposed in spaces of the first housing 210 and/or the second housing 220, and may be exposed to an external environment through at least one hole formed through the first housing 210 and/or the second housing 220. In an embodiment, holes formed through the first housing 210 and/or the second housing 220 may be commonly used for the input device 215 and the sound output devices 227 and 228. In an embodiment, the sound output devices 227 and 228 may include a speaker (e.g., a piezo speaker) operating without including a hole formed through the first housing 210 and/or the second housing 220.

According to an embodiment, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. According to an embodiment, the electronic device 200 may include a flash 218 disposed around the second camera module 216b. According to an embodiment, the flash 218 may include, for example, a light-emitting diode or a xenon lamp. According to an embodiment, the camera modules 216a, 216b, and 225 may include one or multiple lenses, an image sensor, and/or an image signal processor. In an embodiment, at least one of the camera modules 216a, 216b, and 225 may include two or more lenses (e.g., wide-angle and telephoto lenses) and image sensors, and may be arranged together on one surface of the first housing 210 and/or the second housing 220.

According to an embodiment, the sensor modules 217a, 217b, and 226 may generate a data value or an electrical signal corresponding to an internal operational state or an external environmental state of the electronic device 200.According to an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In an embodiment, the sensor modules 217a, 217b, and 226 may include at least one of a gesture sensor, a grip sensor, a color sensor, an infrared (IR) sensor, an illuminance sensor, an ultrasonic sensor, an iris recognition sensor, or a distance detection sensor (e.g., a time of flight (TOF) sensor or a light detection and ranging (LiDAR)).

According to an embodiment, the electronic device 200 may further include an unillustrated sensor module, for example, at least one of an atmospheric sensor, a magnetic sensor, a biometric sensor, a temperature sensor, a humidity sensor, or a fingerprint recognition sensor. In an embodiment, the fingerprint recognition sensor may be disposed through at least one of the first side member 213 of the first housing 210 and/or the second side member 223 of the second housing 220.

According to an embodiment, the key input device 219 may be disposed to be exposed to the outside through the first side member 213 of the first housing 210. In an embodiment, the key input device 219 may be disposed to be exposed to the outside through the second side member 223 of the second housing 220. In an embodiment, the electronic device 200 may not include some or all of the key input device 219, and the unincluded key input device 219 may be implemented in another shape such as a soft key on the least one display 230 and 300. In another embodiment, the key input device 219 may be implemented by using a pressure sensor included in the at least one display 230 and 300.

According to an embodiment, the connector port 229 may include a connector (e.g., a USB connector or an IF module (an interface connector port module)) for transmitting or receiving data and/or power to and/or from an external electronic device. In an embodiment, the connector port 229 may perform a function of transmitting or receiving an audio signal to or from the external electronic device together, or may further include a separate connector port (e.g., an ear jack hole) for performing a function of transmitting or receiving an audio signal to or from the external electronic device.

According to an embodiment, at least one camera modules 216a and 225 of the camera modules 216a, 216b, and 225, at least one sensor module 217a and 226 of the sensor modules 217a, 217b, and 226, and/or an indicator may be arranged to be exposed through the at least one display 230 and 300. For example, the at least one camera modules 216a and 225, the at least one sensor module 217a and 226, and/or the indicator may be arranged under an activated area (a display area) of the at least one display 230 and 300 in a space in the at least one housing 210 and 220, and may be arranged to come into contact with an external environment through a transparent area or an opening that is perforated to a cover member (e.g., a window layer (not shown) of the first display 230 and/or the second rear cover 250). According to an embodiment, an area in which the at least one display 230 and 300 and the at least one camera module 216a and 225 face each other may be formed as a transmission area having a predetermined transmission ratio, as a part of an area in which a content is displayed. According to an embodiment, the transmission area may be formed to have a transmission ratio in the range of about 5% to about 20%. The transmission area may include an area overlapping with an effective area (e.g., an angle of view area) of the at least one camera module 216a and 225, wherein an image is formed on the image sensor in the effective area, and light for generating an image passes through the effective area. For example, the transmission area of the display 230 and 300 may include an area in which the density of a pixel is lower than that in a surrounding area. For example, the transmission area may be replaced with an opening. For example, the at least one camera module 216a and 225 may include an under-display camera (UDC) or an under-panel camera (UPC). In another embodiment, some camera modules or sensor modules 271a and 226 may be arranged to perform functions thereof without being visually exposed through the display. For example, an area facing the sensor module 217a and 226 and/or the camera module 216a and 225 arranged under the display 230 and 300 (e.g., a display panel) corresponds to an under-display camera (UDC) structure, and a perforated opening is not necessarily required.

FIG. 3 is an exploded perspective view illustrating an electronic device 200 according to an embodiment of the disclosure.

Referring to FIG. 3, the electronic device 200 may include a first display 230 (e.g., a display module(230)), a second display 300, a hinge device 400, 400-1, a pair of support members 261 and 262, at least one substrate 270 (e.g., a printed circuit board (PCB)), a first housing 210, a second housing 220, a first rear cover 240, and/or a second rear cover 250.

According to an embodiment, the first display 230 may include a display panel 430 (e.g., a flexible display panel), a support plate 450 disposed under the display panel 430, and a reinforcement plate, or a pair of reinforced plates 461 and 462, arranged under the support plate 450. According to an embodiment, the display panel 430 may include a first panel area 430a corresponding to a first area (e.g., the first area 230a of FIG. 1A) of the first display 230, a second panel area 430b extending from the first panel area 430a and corresponding to a second area (e.g., the second area 230b of FIG. 1A) of the first display 230, and a third panel area 430c for connecting the first panel area 430a and the second panel area 430b and corresponding to a folding area (e.g., the folding area 230c of FIG. 1A) of the first display 230. According to an embodiment, the support plate 450 may be disposed between the display panel 430 and a pair of support members 261 and 262 and may be formed to have a material and a shape for providing a planar support structure for the first panel area 430a and the second panel area 430b and a bendable structure for assisting in the flexibility of the third panel area 430c. According to an embodiment, the support plate 450 may be formed of a conductive material (e.g., metal) or a non-conductive material (e.g., polymer or fiber reinforced plastic (FRP)). According to an embodiment, the pair of reinforced plates 461 and 462 may include, between the support plate 450 and the pair of support members 261 and 262, a first reinforced plate 461 disposed to correspond to at least a part of the first panel 430a and the third panel area 430c, and a second reinforced plate 462 disposed to correspond to at least a part of the second panel area 460b and the third panel area 430c. According to an embodiment, the pair of reinforced plates 461 and 462 may be formed of metal materials (e.g., SUS), and may thus assist in reinforcing of the rigidity and a ground connection structure for the first display 230.

According to an embodiment, the second display 300 may be disposed in a space between the second housing 220 and the second rear cover 250. According to an embodiment, the second display 300 may be disposed in a space between the second housing 220 and the second rear cover 250 so as to allow the second display 300 to be seen from the outside through substantially the entire area of the second rear cover 250.

According to an embodiment, at least a part of the first support member 261 may be bendably coupled to the second support member 262 through the hinge device 400, 400-1. According to an embodiment, the electronic device 200 may include at least one wire member 280 (e.g., a flexible printed circuit board (FPCB)) disposed from at least a part of the first support member 261 to a part of the second support member 262 by crossing the hinge device 400, 400-1. According to an embodiment, the first support member 261 may be disposed by extending from the first side member 213 or structurally coupled to the first side member 213. According to an embodiment, the electronic device 200 may include a first space (e.g., a first space 2101 of FIG. 1A) provided through the first support member 261 and the first rear cover 240. For example, the first space (e.g., first space 2101) may be defined according to a shape of the first support member 261 and a shape of the first rear cover 240, and/or according to a position of the first support member 261 relative to the first rear cover 240. For example, the first space (e.g. first space 2101) may include a space between the first support member 261 and the first rear cover 240, and optionally include a space formed within the first support member 261 (e.g., the first space may include a gap defined in the first support member 261). According to an embodiment, the first housing 210 (e.g., a first housing structure) may be configured by coupling of the first side member 213, the first support member 261, and the first rear cover 240. According to an embodiment, the second support member 262 may be disposed by extending from the second side member 223 or structurally coupled to the second side member 223. According to an embodiment, the electronic device 200 may include a second space (e.g., a second space 2201 of FIG. 1A) provided through the second support member 262 and the second rear cover 250. For example, the second space (e.g., second space 2201) may be defined according to a shape of the second support member 262 and a shape of the second rear cover 250, and/or according to a position of the second support member 262 relative to the second rear cover 250. For example, the second space (e.g. second space 2101) may include a space between the second support member 262 and the second rear cover 250, and optionally include a space formed within the second support member 262 (e.g., the second space may include a gap defined in the second support member 262). According to an embodiment, the second housing 220 (e.g., a second housing structure) may be configured through coupling of the second side member 223, the second support member 262, and the second rear cover 250. According to an embodiment, at least a part of the hinge device 400, 400-1 and/or the at least one wire member 280 may be disposed to be supported through at least a part of the pair of support members 261 and 262. According to an embodiment, the at least one wire member 280 may be disposed in a direction (e.g., an x-axis direction) crossing the first support member 261 and the second support member 262. According to an embodiment, the at least one wire member 280 may be disposed in a direction (e.g., an x-axis direction) substantially perpendicular to a folding axis (e.g., a y-axis or the folding axis A of FIG. 1A).

According to an embodiment, the at least one substrate 270 may include a first substrate 271 disposed in the first space 2101 and a second substrate 272 disposed in the second space 2201. According to an embodiment, the first substrate 271 and the second substrate 272 may include multiple electronic components arranged to implement various functions of the electronic device 200. According to an embodiment, the first substrate 271 and the second substrate 272 may be electrically connected to each other through the at least one wire member 280. In one embodiment, the camera module 282 may be disposed on the first substrate 271.

According to an embodiment, the electronic device 200 may include at least one battery 291 and 292. According to an embodiment, the at least one battery 291 and 292 may include a first battery 291 disposed in the first space 2101 of the first housing 210 and electrically connected to the first substrate 271, and a second battery disposed in the second space 2201 of the second housing 220 and electrically connected to the second substrate 272. According to an embodiment, the first support member 261 and the second support member 262 may further include at least one swelling hole for the first battery 291 and the second battery 292.

According to an embodiment, the first housing 210 may include a first rotation support surface 214, and the second housing 220 may include a second rotation support surface 224 corresponding to the first rotation support surface 214. According to an embodiment, the first rotation support surface 214 and the second rotation support surface 224 may include a curved surface (seamlessly connected) corresponding to an external surface of a curved shape of the hinge housing 310. According to an embodiment, when the electronic device 200 is in the unfolded state, the first rotation support surface 214 and the second rotation support surface 224 may hide the hinge housing 310 not to expose the hinge housing 310 through the rear surface of the electronic device 200 or to expose only a part thereof. According to an embodiment, when the electronic device 200 in the folded state, the first rotation support surface 214 and the second rotation support surface 224 may be at least partially expose the hinge housing 310 through the rear surface of the electronic device 200 as the curved shape of the hinge housing 310 rotates along an external surface.

According to an embodiment, the electronic device 200 may include at least one antenna 276 disposed in the first space 2201. According to an embodiment, the at least one antenna 276 may be disposed on the first battery 291 and the first rear cover 240 in the first space 2201. According to an embodiment, the at least one antenna 276 may include, for example, a near-field communication (NFC) antenna, a wireless charging antenna, and/or a magnetic secure transmission (MST) antenna. According to an embodiment, the at least one antenna 276 may perform, for example, short-distance communication with an external device, or wirelessly transmit or receive power required for charging. In an embodiment, an antenna structure may be formed by at least a part of the first side member 213 or the second side member 223 and/or a part or a combination of the first support member 261 and the second support member 262.

According to an embodiment, the electronic device 200 may further include at least one electronic component assembly 274 and 275 and/or additional support members 263 and 273 disposed in the first space 2101 and/or the second space 2201. For example, the at least one electronic component assembly may include an interface connector port assembly 274 or the speaker assembly 275.

According to an embodiment, the electronic device 100 may include a first waterproof structure WP1 disposed between the first reinforced plate 461 and the first support member 261 and a second waterproof structure WP2 disposed between the second reinforced plate 462 and the second support member 262. According to an embodiment, the first waterproof structure WP1 may include a first waterproof member 481 disposed to have at least one first waterproof space 4811, 4812, and 4813 formed between the first reinforced plate 461 and the first support member 261. According to an embodiment, the second waterproof structure WP2 may include a second waterproof member 482 (e.g., 2-1 waterproof member 482), a third waterproof member 483 (e.g., 2-2 waterproof member 483), and a fourth waterproof member 484 (e.g., 2-3 waterproof member 484) disposed to have at least one second waterproof space 4821 formed between the second reinforced plate 462 and the second support member 262. According to an embodiment, the fourth waterproof member 484 may be disposed in a space between the second waterproof member 482 and the third waterproof member 483 spaced apart from each other, to connect the second waterproof member and the third waterproof member to each other.

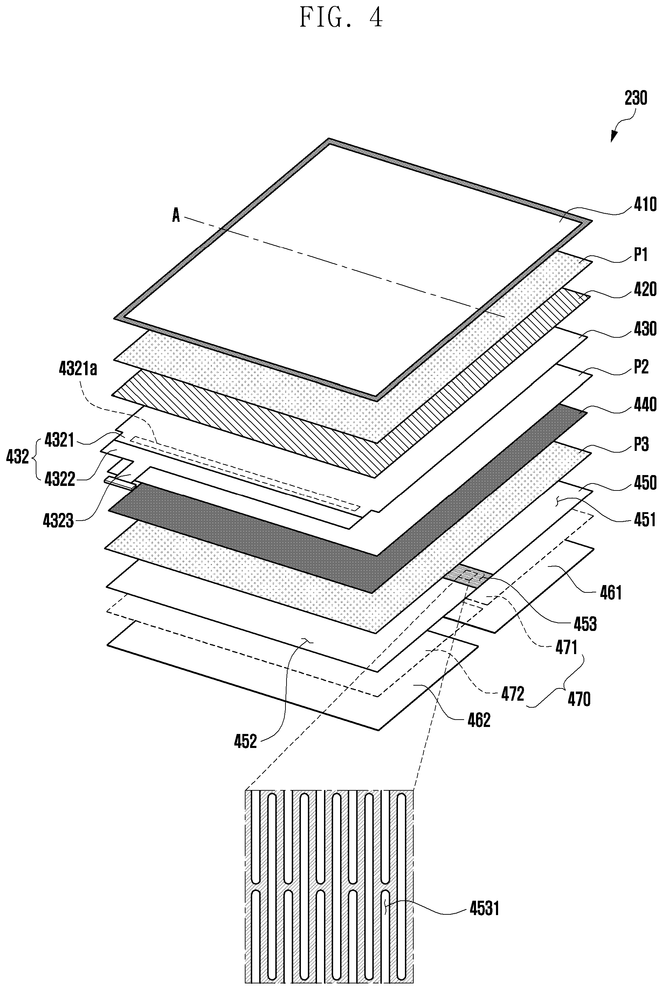

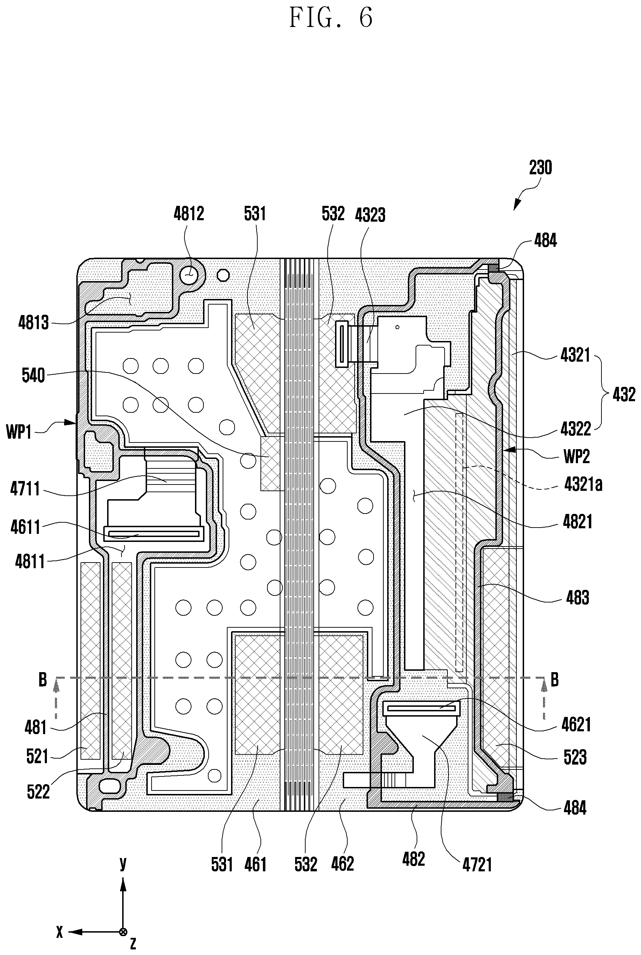

According to an embodiment, the at least one first waterproof space 4811 corresponds to a wire structure for connecting an electronic component (e.g., a first digitizer panel 471 of FIG. 4) disposed between the first reinforced plate 461 and the first support member 261 to the first space 2101 through the first waterproof member 481, and may be disposed to receive a through-path of a connection portion (e.g., a first connection portion 4711 of FIG. 6). According to an embodiment, the at least one second waterproof space 4821 corresponds to a wire structure for connecting an electronic component (e.g., a second digitizer panel 472 of FIG. 4) disposed between the second reinforced plate 462 and the second support member 262 to the second space 2201 through at least one of the second waterproof member 482, the third waterproof member 483, and the fourth waterproof member 484, and may be disposed to receive a through-path of a connection (e.g., a second connection 4721 of FIG. 6). According to an embodiment, the at least one first waterproof space 4812 and 4813 may receive an area corresponding to at least one electronic component (e.g., a camera module or a sensor module) disposed to be supported by the first support member 261. According to an embodiment, the at least one second waterproof space 4821 may receive at least a part of a bending portion (e.g., a bending portion 432 of FIG. 4) bent over a rear surface of the first display 230. For example, the at least one second waterproof space 4821 may be disposed to extend from a display panel (e.g., a display panel 430 of FIG. 4) of the first display 230 and surround at least a part of the bending portion 432 bent over the rear surface. Accordingly, multiple electrical elements (not shown) and a control circuit (e.g., a control circuit 4321a of FIG. 4) disposed on the bending portion 432 may be disposed in the at least one second waterproof space 4821, so as to be protected from water and/or a foreign material from the outside.

In the electronic device 200 according to an exemplary embodiment of the disclosure, the at least one waterproof member 481, 482, 483, and 484 may be included in at least one waterproof structure WP1 and WP2 disposed between the first support member 261 of the first housing 210 and the first reinforced plate 461 and/or between the second support member 262 of the second housing 220 and the second reinforced plate 462, so that a phenomenon in which the first display is damaged when the first display 230 is separated from the housings 210 and 220 for maintenance of the electronic device 200 can be reduced through a waterproof member, and the at least one waterproof member 481, 482, 483, and 484 is disposed to avoid the rear surface of the first display 230, and thus, external visibility can be enhanced and a surface quality can be secured.

FIG. 4 is an exploded perspective diagram of a display module according to an embodiment of the disclosure. The display module in FIG. 4 may be an example of the first display (e.g., the first display 230 in FIGS. 1A and 3) described above (e.g. with reference to FIGS. 1A and 3).

A display module 230 according to exemplary embodiments of the disclosure may include an "unbreakable" (UB)-type OLED display (e.g., a curved display). However, the disclosure is not limited thereto, and the display module 230 may include a flat type display of an on-cell touch active matrix organic light-emitting diode (AMOLED) (OCTA) type.

Referring to FIG. 4, the display module 230 may include a window layer 410, and a polarizer (POL) 420 (e.g., a polarizing film), a display panel 430, a polymer layer 440, a support plate 450, and reinforced plates 461 and 462, sequentially disposed on the rear surface (e.g., the -z-axis direction) of the window layer 410. In some embodiments, the display module 230 may have a damping layer 420 disposed between the window layer 410 and the display panel 430 instead of the polarizer 420. Also, in some embodiments, the damping layer 420 may be disposed on or beneath the polarizer 420.

In some embodiments, the display module 230 may include a digitizer panel 470 disposed between the support plate 450 and the reinforced plates 461 and 462. In some embodiments, the digitizer panel 470 may be disposed between the polymer layer 440 and the support plate 450. Although not illustrated in the drawing, in an embodiment, a buffer member (not shown) may be disposed between the window layer 410 and the support plate 450. The buffer member may mitigate impact transmitted from the window layer 410 to the support plate 450. Accordingly, it will be appreciated that, in various embodiments, one or more layer illustrated in Fig. 4 may be provided in a different location in the display module 230 to that illustrated (e.g., on top of or below a different layer in the stack to that illustrated in Fig. 4), one or more additional layer may be included in the display panel 470, and/or one or more illustrated layer may be omitted if not essential.

According to an embodiment, the window layer 410 may include a glass layer. In some embodiments, the window layer 410 may have a protective film disposed thereon. For example, the protective film may be disposed on the top of the window layer 410 to protect the window layer 410 from external impact. According to an embodiment, the window layer 410 may include ultra-thin glass (UTG). In some embodiments, the window layer 410 may include a polymer. In this case, the window layer 410 may include polyethylene terephthalate (PET) or polyimide (PI). In some embodiments, the window layer 410 may be disposed in multiple layers including a glass layer and a polymer.

According to an embodiment, the window layer 410, the polarizer 420, the display panel 430, the polymer layer 440, and the support plate 450 may be disposed to cross at least a part of each of a first surface (e.g., the first surface 211 in FIG. 1A) of a first housing (e.g., the first housing 210 in FIG. 1A) and a third surface (e.g., the third surface 221 in FIG. 1A) of a second housing (e.g., the second housing 220 in FIG. 1A). In other words, in various examples, the window layer 410, the polarizer 420, the display panel 430, the polymer layer 440, and the support plate 450 are provided across at least part of the first surface 211 and at least part of the third surface 221. According to an embodiment, the reinforced plates 461 and 462 may include a first reinforced plate 461 corresponding to the first housing (e.g., the first housing 210 in FIG. 1A) and a second reinforced plate 462 corresponding to the second housing (e.g., the second housing 220 in FIG. 1A). For example, the first reinforced plate 461 may be disposed within the first housing 210, and the second reinforced plate 462 may be disposed within the second housing 220. According to an embodiment, the reinforced plates 461 and 462 may provide rigidity for the display module 230, and may be used as grounds for preventing malfunction of the display module 230. According to an embodiment, the reinforced plates 461 and 462 may be formed of a metal material. According to an embodiment, the reinforced plates 461 and 462 may be formed of SUS, Cu, or Al. According to an embodiment, the window layer 410, the polarizer 420, the display panel 430, the polymer layer 440, the support plate 450, and the reinforced plates 461 and 462 may be attached to each other by adhesives P1, P2, P3 (or adhesives). For example, the adhesives P1, P2, and P3 may include at least one among an optical clear adhesive (OCA), a pressure-sensitive adhesive (PSA), a heat-reactive adhesive, a normal adhesive, or a double-sided tape.

According to an embodiment, the display panel 430 may include multiple pixels and a wiring structure (e.g., an electrode pattern). According to an embodiment, the polarizer 420 may selectively allow light, which is generated from a light source of the display panel 430 and vibrates in a predetermined direction, to pass therethrough. According to an embodiment, the display panel 430 and the polarizer 420 may be integrally formed. According to an embodiment, the display module 230 may include a touch panel (not shown).

According to an embodiment, the polymer layer 440 may be disposed beneath the display panel 430, thereby providing a dark background for securing visibility of the display panel 430, and may be formed as a buffering material for a buffering action. In some embodiments, in order to waterproof the display module 230, the polymer layer 440 may be removed or placed under the support plate 450.

According to an embodiment, the support plate 450 may provide bending characteristics to the display module 230. For example, the support plate 450 may be formed of a non-metallic thin plate material, such as fiber reinforced plastics (FRP) (e.g., carbon fiber reinforced plastics (CFRP) or glass fiber reinforced plastics (GFRP), having rigid characteristics for supporting the display panel 430. According to an embodiment, the support plate 450 may include a first flat portion 451 corresponding to the first housing (e.g., the first housing 210 in FIG. 1A), a second flat portion 452 corresponding to the second housing (e.g., the second housing 220 in FIG. 1A), and a bending portion 453 (a flexible portion) connecting the first flat portion 451 to the second flat portion 452. According to an embodiment, the bending portion 453 may include multiple openings 4531 (e.g., multiple patterns 4531) disposed at designated intervals. According to an embodiment, the bending characteristics of the bending portion 453 may be determined through at least one of the size, shape, or arrangement density of at least some of the multiple openings 4531. In some embodiments, the support plate 450 may be formed of a metal material such as steel use stainless (SUS) (e.g., stainless steel (STS)), Cu, Al, or metal CLAD (e.g., a stacked member in which SUS and Al are alternately disposed). In this case, multiple openings may be formed through the entire area of the support plate 450 so that the detection operation of the digitizer panel 470 disposed below is guided. According to an embodiment, the support plate 450 may help reinforce the rigidity of an electronic device (e.g., the electronic device 200 in FIG. 1A), and may be used to shield ambient noise and dissipate heat emitted from surrounding heat-emitting elements.

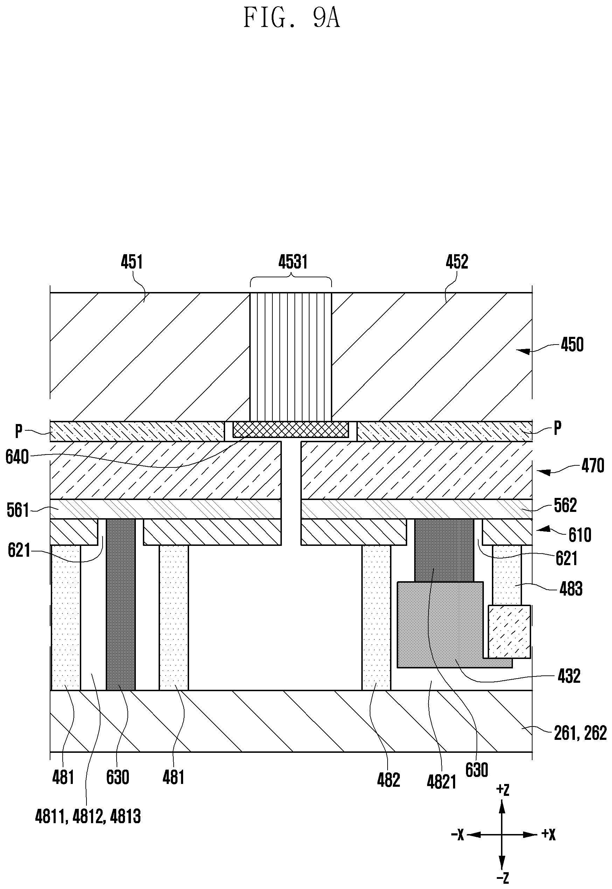

According to an embodiment, the display module 230 may include a foreign matter blocking member 640 (e.g., foreign matter blocking member 640 in FIG. 9A). The foreign matter blocking member 640 may cover the openings 4531 formed in the support plate 450 to block external foreign matter that may be introduced through the openings 4531. For example, the foreign matter blocking member 640 may be disposed on the rear surface of the support plate 450 and positioned to correspond to the bending portion 453(or the folding area 230c) of the display module 230. In some embodiments, the foreign matter blocking member 640 may extend to a portion of a first panel area 430a and/or a portion a second panel area 430b of the display module 230.

According to an embodiment, the display module 230 may include a cushion layer 650. The cushion layer 650 is disposed under the support plate 450 to soften an impact applied to the display module 230. In an embodiment, the cushion layer 650 may be disposed on rear surfaces of reinforced plates 561 and 562. For example, the cushion layer 650 may be positioned to correspond to the folding area 230c of the display module 230. In some embodiments, the cushion layer 650 may extend to a portion of the first panel area 430a and/or a portion of the second panel area 430b of the display module 230. Although not illustrated in the drawing, in some embodiments, the cushion layer 650 may be disposed on the rear surface of the foreign matter blocking member 640. For example, the cushion layer 650 may be positioned between the foreign matter blocking member 640 and the reinforced plates 561 and 562.

According to an embodiment, the display module 230 may include the digitizer panel 470 as a detection member which is disposed beneath the support plate 450 and receives an input of an electronic pen (e.g., stylus). According to an embodiment, the digitizer panel 470 may include coil members disposed on a dielectric substrate (e.g., a dielectric film or a dielectric sheet) to detect an electromagnetic induction-type resonance frequency applied from an electronic pen. According to an embodiment, the digitizer panel 470 may include a first digitizer panel 471 corresponding to the first housing (e.g., the first housing 210 in FIG. 1A) and a second digitizer panel 472 corresponding to the second housing (e.g., the second housing 220 in FIG. 1A). According to an embodiment, the first digitizer panel 471 and the second digitizer panel 472 are may be electrically connected to substrates (e.g., the substrates 271 and 272 in FIG. 3) of the electronic device (e.g., the electronic device 200 in FIG. 3) through connection members (e.g., a connection member 4711 and a second connection member 4721 in FIG. 6), respectively, so as to operate as one digitizer panel. In some embodiments, the first digitizer panel 471 and the second digitizer panel 472 may be operated separately. In some embodiments, the first digitizer panel 471 and the second digitizer panel 472 may be integrally formed and operate separately.

According to an embodiment, the display module 230 may include at least one functional member (not shown) disposed between the polymer layer 440 and the support plate 450 or under the support plate 450. According to an embodiment, the functional member may include a graphite sheet for heat dissipation, an added display, a force touch FPCB, a fingerprint sensor FPCB, an antenna radiator for communication, or a conductive/non-conductive tape. According to an embodiment, functional members may be separately disposed in the first housing (e.g., the first housing 210 in FIG. 1A) and the second housing (e.g., the second housing 220 in FIG. 1A) when the functional members cannot be bent. According to an embodiment, when a functional member is bendable, the functional member may be disposed from the first housing (e.g., the first housing 210 in FIG. 1A) to at least a portion of the second housing (e.g., at least a part of the second housing 220 in FIG. 1A) via a hinge device (e.g., the hinge device 400, 400-1 in FIG. 3).

According to an embodiment, the display module 230 may include a bending portion 432 disposed to be bent from the display panel 430 to at least a partial area of the rear surface (e.g., the -z-axis direction) of the display module 230. According to an embodiment, the bending portion 432 may include an extension portion 4321 extending from the display panel 430 and including a control circuit 4321a, and a flexible substrate 4322 electrically connected to the extension portion 4321 and including multiple electrical elements. According to an embodiment, the control circuit 4321a may include a display driver IC (DDI) or a touch display driver IC (TDDI) mounted to the extension portion 4321 having an electrical wiring structure. According to an embodiment, the control circuit 4321a may have a chip-on-panel or chip-on-plastic (COP) structure in which control circuit 4321a is directly disposed on the extension portion 4321. In some embodiments, the control circuit 4321a may have a chip-on-film (COF) structure in which the control circuit 4321a is mounted on a separate connection film (not shown) for connecting the extension portion 4321 to the flexible substrate 4322. According to an embodiment, the display module 230 may include multiple electrical elements (not shown) disposed on the flexible substrate 4322. According to an embodiment, the display module 230 may include a connection member 4323 extending from the flexible substrate 4322 and electrically connected to a substrate (e.g., the second substrate 272 in FIG. 3) of the electronic device (e.g., the electronic device 200 in FIG. 3). According to an embodiment, the multiple electrical elements may include a touch IC, a flash memory for a display, a diode for preventing ESD, a pressure sensor, a fingerprint sensor, or a passive element such as a decap. In another embodiment, when the bending portion 432 is disposed in an area of the display module 230 facing the first housing (e.g., the first housing 210 in FIG. 1A), the connection member 4323 may be electrically connected to another substrate (e.g., the first substrate 271 in FIG. 3 ) of the electronic device (e.g., the electronic device 200 in FIG. 3).

According to an embodiment, at least one hinge device 400 or 400-1 may include a first hinge device 400 disposed at one end in a direction parallel to a folding axis A and a second hinge device 400-1 disposed at the other end. According to an embodiment, the first hinge device 400 and the second hinge device 400-1 may have substantially the same configuration. According to an embodiment, the electronic device 200 may include a connection module 400-2 disposed between the first hinge device 400 and the second hinge device 400-1. According to an embodiment, the connection module 400-2 may be disposed through a combination of at least one gear and/or a combination of at least one link. In an embodiment, the connection module 400-2 may be replaced by the first hinge device 400. In an embodiment, the at least one hinge device 400 or 400-1 may be disposed at one location or at three or more locations spaced apart from each other along a direction parallel to the folding axis A. According to an embodiment, the electronic device 200 may include a first hinge plate 311 and a second hinge plate 312 connected to each other through the at least one hinge device 400 or 400-1. According to an embodiment, the first hinge plate 311 may form the same plane with the first housing 210 in an unfolded state of the electronic device 200, and the second hinge plate 312 may form the same plane with the second housing 220 in the unfolded state of the electronic device 200. According to an embodiment, in a folded state of the electronic device 200, the first display 230 may be deformed into a shape having a designated curved surface (e.g., a "U" shape or a waterdrop shape) through the at least one hinge device 400 or 400-1 and accommodated in the inner space of the electronic device 200. According to an embodiment, in the folded state of the electronic device 200, the first hinge plate 311 and the second hinge plate 312 may be moved to support at least a portion of a folding area (e.g., the folding area 230c in FIG. 2A) of the first display 230 deformed into a shape having a curved surface. In an embodiment, in the folded state of the electronic device 200, the first housing 210 and the second housing 220 are moved to support substantially undeformed flat portions (e.g., the first area 230a and the second area 230b in FIG. 2A) of the first display 230. In an embodiment, in the folded state of the electronic device 200, the first hinge plate 311 may not form the same plane with the first housing 210, and the second hinge plate 312 may not form the same plane with the second housing 220 either.

According to exemplary embodiments of the disclosure, an electronic device (e.g., the electronic device 200 in FIG. 3) may include waterproof structures (e.g. WP1 and/or WP2) for protecting, from external moisture and/or foreign matter, a wiring structure of a connection member (e.g., connection members 4711 and 4721 of FIG. 6) drawn out from the digitizer panel 470 disposed on the rear surface of the display module 230, at least a portion (e.g., the extension portion 4321) of the bending portion 432 bent toward the rear surface of the display module 230 and including the control circuit 4321a and multiple electrical elements, and areas corresponding to at least one electronic component (e.g., a camera module or a sensor module) disposed through the support members 261 and 262.

The display module 230 described above is only an example for describing the disclosure, and the display module 230 does not necessarily include all the elements described above. Therefore, it may be possible to configure the display module 230 by omitting or adding some of the elements described above.

According to an embodiment, the display module 230 may include the foreign matter blocking member 640 and the cushion layer 650. The foreign matter blocking member 640 may cover the openings 4531 formed in the support plate 450 to block external foreign matter that may be introduced through the openings 4531. The foreign matter blocking member 640 may be formed of elastomer which is a polymer material having elasticity. In some embodiments, the foreign matter blocking member 640 may include thermoplastic polyurethane (TPU).

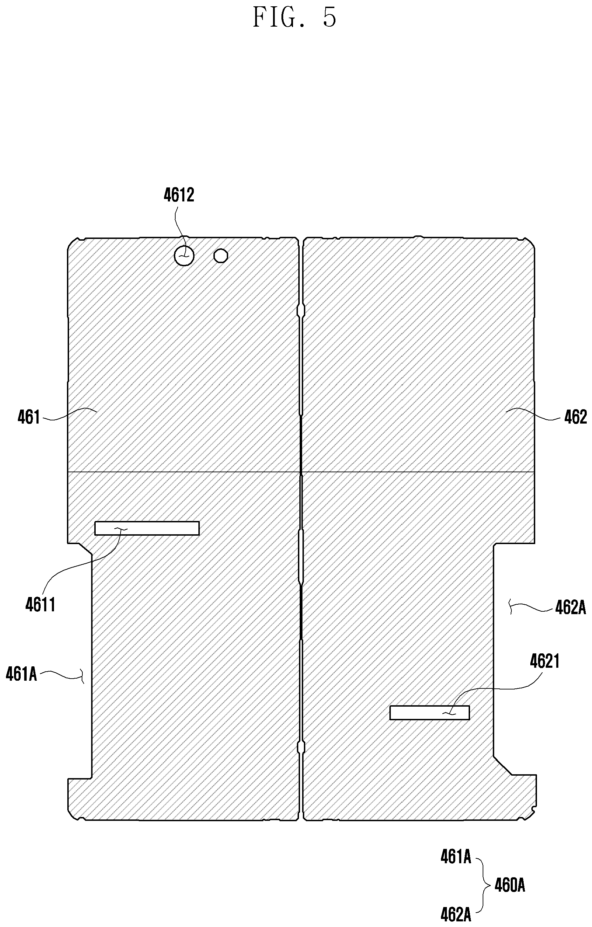

FIG. 5 illustrates the configuration of reinforced plates according to an embodiment of the disclosure. FIG. 6 illustrates a rear structure of a display module according to an embodiment of the disclosure.

Referring to FIGS. 5 and 6, an electronic device (e.g., the electronic device 200 in FIG. 3) may include a first reinforced plate 461 corresponding to (e.g., disposed within) a first housing (e.g., the first housing 210 in FIG. 1A) and a second reinforced plate 462 corresponding to (e.g. disposed within) a second housing (e.g., the second housing 220 in FIG. 1A). According to an embodiment, a first digitizer panel (e.g., the first digitizer panel 471 in FIG. 4) may be disposed between a support plate (e.g., the support plate 450 in FIG. 4) and the first reinforced plate 461, and a first connection member 4711 of the first digitizer panel 471 may be electrically connected, through the first reinforced plate 461, to a substrate (e.g., the first substrate 271 in FIG. 3) disposed in a first space (e.g., the first space 2101 in FIG. 1A) of the first housing (e.g., the first housing 210 in FIG. 1A). Accordingly, the first reinforced plate 461 may include a first through-hole 4611 through which the first connection member 4711 passes. According to an embodiment, a second digitizer panel (e.g., the second digitizer panel 472 in FIG. 4) may also be disposed between the support plate (e.g., the support plate 450 in FIG. 4) and the second reinforced plate 462, and a second connection member 4721 of the second digitizer panel 472 may be electrically connected, through the second reinforced plate 462, to a substrate (e.g., the second substrate 272 in FIG. 3) disposed in a second space (e.g., the second space 2201 in FIG. 1A) of the second housing (e.g., the second housing 220 in FIG. 1A). Accordingly, the second reinforced plate 462 may include a second through-hole 4621 through which the second connection member 4721 passes. According to an embodiment, the first reinforced plate 461 may include at least one hole 4612 for at least one electronic component (e.g., a camera module or a sensor module) arranged to be supported by a first support member (e.g., the first support member 261 in FIG. 3). For example, the at least one electronic component may be disposed to correspond to the at least one hole 4612, so that the external environment may be detected through the display module 230.

According to an embodiment, the electronic device (e.g., the electronic device 200 in FIG. 3) may include a first waterproof structure WP1 disposed between the first reinforced plate 461 and the first support member (e.g., the first support member 261 in FIG. 3) of the first housing (e.g., the first housing 210 in FIG. 3), and a second waterproof structure WP2 disposed between the second reinforced plate 462 and a second support member (e.g., the second support member 262 in FIG. 3) of the second housing (e.g., the second housing 220 in FIG. 3). According to an embodiment, the first waterproof structure WP1 may include at least one first waterproof space 4811, 4812, or 4813 formed through a first waterproof member 481. According to an embodiment, the first waterproof member 481 may include at least one among tape, adhesive, waterproof dispensing, silicone, waterproof rubber, and urethane. According to an embodiment, at least one first waterproof space 4811 may include a first waterproof space 4811 having a closed loop shape, a second waterproof space 4821 having a closed loop shape and spaced apart from the first waterproof space 4811, and a third waterproof space 4813 (e.g., the first waterproof space 4813) having a closed loop shape and spaced apart from the second waterproof space 4821. According to an embodiment, the first through-hole 4611 may be disposed at a position at least partially overlapping the first waterproof space 4811 when the first reinforced plate 461 is viewed from above. According to an embodiment, the at least one hole 4612 may be disposed at a position overlapping at least a part of the second waterproof space 4821 when the first reinforced plate 461 is viewed from above. The third waterproof space 4813 may be disposed at a position in which at least one electronic component (e.g., a sensor module) overlaps.

According to an embodiment, the second waterproof structure WP2 may include the second waterproof space 4821 having a closed loop shape and formed by a (2-1)th waterproof member 482, a (2-2)th waterproof member 483, and the (2-3)th waterproof member 484. According to an embodiment, the second through-hole 4621 may be disposed at a position overlapping at least a part of the second waterproof space 4821 when the second reinforced plate 462 is viewed from above. According to an embodiment, the second waterproof space 4821 may be formed by the (2-1)th waterproof member 482 disposed between the second reinforced plate 462 and the second support member 262 and surrounding at least a portion of the bending portion 432, the (2-2)th waterproof member 483 disposed between the extension portion 4321 and the second support member 262, and the (2-3)th waterproof member 484 connecting the (2-1)th waterproof member 482 to the (2-2)th waterproof member 483. According to an embodiment, the (2-1)th waterproof member 482 and the (2-2)th waterproof member 483 may include at least one among tape, adhesive, waterproof dispensing, silicone, waterproof rubber, and urethane. According to an embodiment, when the (2-1)th waterproof member 482 and the (2-2)th waterproof member 483 are integrally formed, moisture or foreign matter may be introduced into a gap formed by the height difference (step difference) between the bending portion 432 and the second reinforced plate 462. According to an embodiment, the (2-1)th waterproof member 482 may be attached while being spaced a designated interval apart from the (2-2)th waterproof member 483 at the above-described stepped portion, and the stepped portion including the interval may be connected without a gap through the (2-3)th waterproof member 484. For example, the (2-1)th waterproof member 482 may be provided or formed separately to the (2-2)th waterproof member 483, with the (2-1)th waterproof member 482 then being connected to the (2-2)th waterproof member 483 via provision or formation of the (2-3)th waterproof member 484 such that the aforementioned gap is not formed. According to an embodiment, the (2-3)th waterproof member 484 may include a cured-in-place gasket (CIPG) (e.g., a waterproof filling member), which includes a semi-solid or liquid material and thus has the property of being solidified by natural or external conditions (e.g., heat, ultraviolet rays, moisture, or pressure).

According to an embodiment, when the second reinforced plate 462 is viewed from above, the second through-hole 4621 may be disposed at a position overlapping at least a part of the second waterproof space 4821. According to an embodiment, the display module 230 may include a third connection member 4323 extending from the flexible substrate 4322 of the bending portion 432. According to an embodiment, the third connection member 4323 may be electrically connected, through the second support member 262, to the substrate (e.g., the second substrate 272 in FIG. 3) disposed in the second space (e.g., the second space 2201 in FIG. 1A). According to an embodiment, an area in which the third connection member 4323 is disposed may also be disposed in an area overlapping at least a part of a second space 2201 when the second reinforced plate 462 is viewed from above. Accordingly, since the second through-hole 4621 and the third connection member 4323 are located in the second waterproof space 4821 having a closed loop shape, penetration of moisture and foreign matter may be prevented.

According to an embodiment, as illustrated in FIG. 5, the first reinforced plate 461 and the second reinforced plate 462 may include concavely formed portions. For convenience of description, these portions will be referred to as removed areas 460A. Referring to FIG. 5 , the removed areas 460A may be portions formed to be concave from outer edges of the first reinforced plate 461 and the second reinforced plate 462 toward the center of the first reinforced plate 461 and the second reinforced plate 462.

For example, the removed areas 460A may be formed by removing (e.g., cutting) portions of the first reinforced plate 461 and the second reinforced plate 462, or the first reinforced plate 461 and the second reinforced plate 462 may be manufactured in a shape including the removed areas 460A .

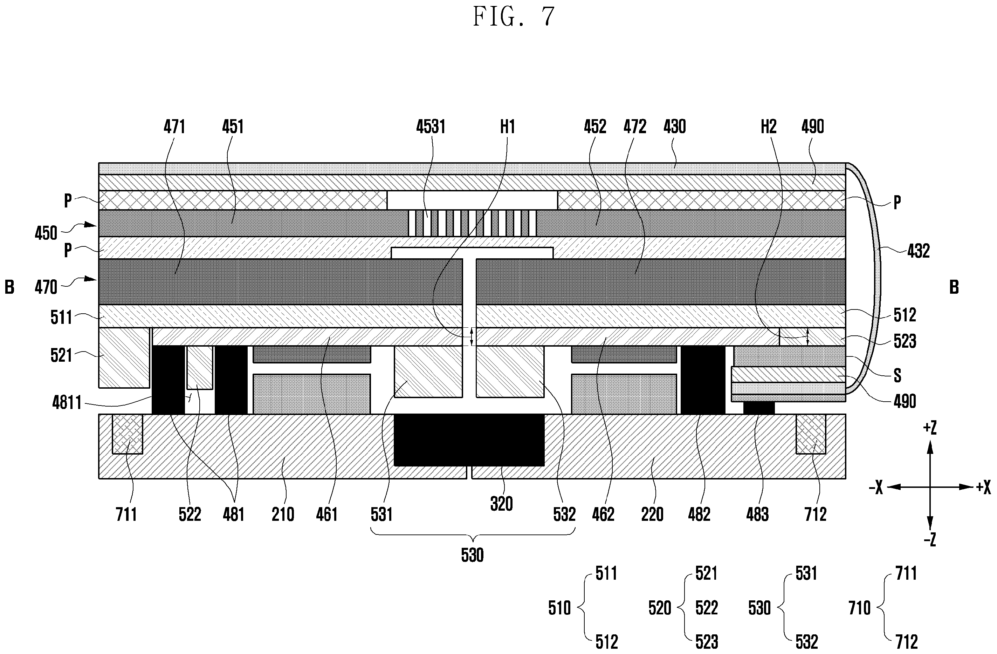

In various embodiments, the removed areas 460A may be areas corresponding to positions in which a magnet member (e.g., a magnet member 710 in FIG. 7) and shielding members 521 and 523 for shielding the magnetic force of the magnet member are disposed. The magnet member may be disposed adjacent to a side portion of the electronic device so as to retain the folded state of the electronic device through magnetic force. For example, a first magnet (e.g., a first magnet 711 in FIG. 7) may be disposed in a first removed area 461A included in the first reinforced plate 461, and A second magnet (e.g., a second magnet 712 in FIG. 7) may be disposed in a second removed area 462A included in the second reinforced plate 462. When the electronic device is in a folded state and when the first reinforced plate 461 and the second reinforced plate 462 face each other, the folded state of the electronic device may be retained by the attractive force between a first magnetic member and a second magnetic member.

Referring to FIG. 6, the shielding members 521 and 523 may be disposed in the removed areas. The waterproof member 481 may be disposed between the shielding members 521 and 522.

FIG. 7 is a diagram obtained by cutting the display module illustrated in FIG. 6 along line B-B and schematizing cross-sections of the display module and peripheral elements thereof.

An electronic device according to an embodiment disclosed herein may include a shielding structure. In the operation of electronic components, electromagnetic waves generated from the outside may cause problems in the operation of the electronic components. The shielding structure may block electromagnetic interference (EMI) or block interference by a magnetic field generated from a magnetic object so that the electronic components included in the electronic device can operate normally within a configured operation range. The shielding structure may include a shielding member formed of various materials capable of performing an EMI shielding function. The shielding member may include, for example, a material made of a material such as metal, carbon, or conductive polymer, or a combination thereof. In an embodiment, the shielding member may be an ARS. The shielding member may be manufactured in various forms. For example, the shielding member may be manufactured in the form of a sheet or film.

In the digitizer panel 470, which recognizes an input of a pen input device by using an electromagnetic resonance (EMR), pen recognition performance may be degraded due to an external magnetic field. Accordingly, a shielding member capable of shielding a magnetic field may be disposed between the digitizer panel 470 and an element generating a magnetic field. For example, elements such as a magnet member 710, the hinge device 400, 400-1, and a sensor member of the electronic device may generate a magnetic field, and thus a shielding member may be disposed between and the digitizer panel 470 and these elements.

In an embodiment, the electronic device may include the magnet member 710. The magnet member 710 may include a first magnet 711, disposed in the first housing 210, and a second magnet 712, disposed in the second housing 220. The first magnet 711 and the second magnet 712 may be disposed at portions corresponding to the first housing 210 and the second housing 220, respectively. The first housing 210 and the second housing 220, when facing each other with the electronic device folded, may maintain a state in which the first housing 210 and the second housing 220 are attached to or attracted towards each other through the magnetic force (attractive force) of the first magnet 711 and the second magnet 712. This state may be maintained until an external force greater than or equal to magnetic force is applied to the housings 210 and 220.

According to an embodiment, shielding members 510, 520, 530, and 540 may include a first shielding member 510, a second shielding member 520, a third shielding member 530, and a fourth shielding member 540. The classification of the above shielding members is only made for convenience according to the position where the shielding members are disposed, and is not made for the number or types of the shielding members. Also, at least one of the first shielding member 510 to the fourth shielding member 540 may be omitted, and a shielding member may also be disposed at another position which has not been described herein.

The first shielding member 510, the second shielding member 520, and the third shielding member 530 may shield elements that generate magnetic fields in various positions; e.g., the first shielding member 510, the second shielding member 520, and the third shielding member 530 may shield components that generate magnetic fields from being interfered with by other components, and/or may shield components that generate magnetic fields from interfering with other components. For example, the first shielding member 510 may be disposed on the rear surface of the digitizer panel 470. The first shielding member 510 may include, for example, magnetic metal powder (MMP). The second shielding member 520 may be disposed on the rear surface of the first shielding member 510 and the rear surfaces of the reinforced plates 461 and 462. The third shielding member 530 may be disposed between the hinge device 400, 400-1 and the display module 230. The fourth shielding member 540 may be disposed between the sensor member and the display module 230.

Referring to FIG. 7, the display module 230 may include a structure in which multiple layers are stacked. The layers of the display module 230 may include the display panel 430, the support plate 450, the digitizer panel 470, the reinforced plates 461 and 462. The layers included in the display module 230 may be mutually fixed by an adhesive P. Since the display module 230 illustrated in FIG. 7 is similar to the display module 230 illustrated in FIG. 4, identical or similar elements are described using identical member numbers, and detailed descriptions thereof will be omitted.

In an embodiment, a polymer film 490 may be disposed on the rear surface of the display panel 430. The polymer film 490 may also be disposed on the bending portion 432 extending to the rear surface of the display panel 430.

In an embodiment, the digitizer panel 470 may be disposed in a first direction (e.g., the -Z direction in FIG. 7) with respect to the display panel 430. The digitizer panel 470 may include the first digitizer panel 471, disposed in an area corresponding to the first housing 210, and the second digitizer panel 472, disposed in an area corresponding to the second housing 220. As illustrated in FIG. 7, the first digitizer panel 471 and the second digitizer panel 472 may be separate from each other. In some embodiments, the first digitizer panel 471 and the second digitizer panel 472 may be integrally formed.

In an embodiment, the reinforced plates 461 and 462 may be disposed on the rear surface of the first shielding member 510. Referring to FIG. 7, the reinforced plates 461 and 462 may include the first reinforced plate 461, disposed on the rear surface of a (1-1)th shielding member 511, and the second reinforced plate 462, disposed on the rear surface of a (1-2)th shielding member 512. The reinforced plates 461 and 462 may be disposed on the rear surface of the first shielding member 510 in an area adjacent to the hinge device 400, 400-1.

In an embodiment, the second shielding member 520 may include a (2-1)th shielding member 521, a (2-2)th shielding member 522, and a (2-3)th shielding member 523. The (2-1)th shielding member 521 and the (2-2)th shielding member 522 may be the second shielding member 520 disposed in an area corresponding to the first housing 210, and the (2-3)th shielding member 523 may be the second shielding member 520 disposed in an area corresponding to the second housing 220 .

Referring to FIG. 7, the (2-1)th shielding member 521 may be disposed on the rear surface of the (1-1)th shielding member 511, and the (2-2)th shielding member 522 may be disposed on the rear surface of the first reinforced plate 461. In an embodiment, in order for the (2-1)th shielding member 521 to be disposed on the rear surface of the (1-1)th shielding member 511, a portion of the first reinforced plate 461 may be removed or the size of the first reinforced plate 461 may be adjusted (the first removed area 461A in FIG. 5). The (2-1)th shielding member 521 and the (2-2)th shielding member 522 may be spaced apart from each other. Referring to FIGS. 6 and 7, the first waterproof member 481 may be disposed between the (2-1)th shielding member 521 and the (2-2)th shielding member 522. The (2-1)th shielding member 521 and the (2-2)th shielding member 522 are separate elements, and may be disposed with the first waterproof member 481 interposed therebetween. In some embodiments, the (2-1)th shielding member 521 and the (2-2)th shielding member 522 may be integrally formed and separated through a separation method such as cutting, and the first waterproof member 481 may be disposed between the (2-1)th shielding member 521 and the (2-2)th shielding member 522.

Referring to FIG. 7, the (2-1)th shielding member 521 may be disposed between the first magnet 711 and the first digitizer panel 471. The (2-1)th shielding member 521 and the (2-2)th shielding member 522 may shield a magnetic field generated from the first magnet 711 to reduce the effect of the magnetic field on the operation of the digitizer panel 470. The first magnet 711 is an element for maintaining the folded state of the first housing 210 and the second housing 220, and may be disposed at the outer periphery of the first housing 210. The (2-1)th shielding member 521 and the (2-2)th shielding member 522 are elements for shielding the first magnet 711, and thus may be positioned adjacent to the first magnet 711.

Referring to FIGS. 6 and 7, the (2-2)th shielding member 522 may be disposed in the first waterproof space 4811 formed to be surrounded by the first waterproof member 481. On the other hand, the (2-1)th shielding member 521 is disposed outside the first waterproof space 4811, and thus may be exposed to moisture. In an embodiment, the (2-1)th shielding member 521 may include a waterproof structure that can be resistant to moisture. On the other hand, the (2-2)th shielding member 522 disposed inside the waterproof space may be configured to have a non-waterproof structure.

Referring to FIG. 7, the (2-3)th shielding member 523 may be disposed on the rear surface of the (1-2)th shielding member 512. In order for the (2-3)th shielding member 523 to be disposed on the rear surface of the (1-2)th shielding member 512, a portion of the second reinforced plate 462 may be removed, or the size of the second reinforced plate 462 may be adjusted (the second removed area 462A in FIG. 5). The (2-3)th shielding member 523 may be positioned between the second magnet 712 and the second digitizer panel 472. The (2-3)th shielding member 523 may shield a magnetic field generated from the second magnet 712.

As illustrated in FIG. 7, the bending portion 432 connected to the display panel 430 may extend to the rear surface of the second reinforced plate 462, and the bending portion 432 extending to the rear surface of the second reinforced plate 462 may face the second reinforced plate 462 and the (2-3)th shielding member 523. A step compensating member S for filling the space between the bending portion 432 and the second reinforced plate 462 and the (2-3)th shielding member 523 may be disposed between the bending portion 432, and the second reinforced plate 462 and the (2-3)th shielding member 523. When there is a step at the boundary portion between the second reinforced plate 462 and the (2-3)th shielding member 523, a defect may occur in the bending portion 432 facing the second reinforced plate 462 and the (2-3)th shielding member 523. In order to reduce the step between the second reinforced plate 462 and the (2-3)th shielding member 523, the (2-3)th shielding member 523 may be formed to have a thickness H2 substantially equal to the thickness H1 of the second reinforced plate 462. Here, the wording "substantially equal" may imply equalizing thicknesses, and may include making slightly different thicknesses due to various causes (e.g., process errors).

In an embodiment, the third shielding member 530 may be disposed between the hinge device 400, 400-1 and the display module 230. In an embodiment, the hinge device 400, 400-1 may include a magnetic body, or may include a material that can be magnetized by a surrounding magnetic body. When the hinge device 400, 400-1 includes a magnetic body or is magnetized, a magnetic field is generated in the hinge device 400, 400-1, and this magnetic field may affect the operation of the digitizer panel. The third shielding member 530 may shield the magnetic field of the hinge device 400, 400-1.

Referring to FIGS. 6 and 7, the third shielding member 530 may be disposed on the rear surface of the reinforced plates 461 and 462. The third shielding member 530 may include a (3-1)th shielding member 531, disposed on the rear surface of the first reinforced plate 461, and a (3-2)th shielding member 532, disposed on the rear surface of the second reinforced plate 462. As illustrated in FIG. 6 , multiple (3-1)th shielding members 531 may be disposed while being spaced apart from each other. Also, multiple (3-2)th shielding members 532 may disposed while being spaced apart from each other.

In an embodiment, the fourth shielding member 540 may be disposed between a sensor member (not shown) and the display module 230. In some embodiments, the electronic device may include a sensor member so as to detect a folded or unfolded state of the electronic device. In an embodiment, the sensor member may include a Hall sensor (not shown) and a magnet (not shown) positioned to correspond to the Hall sensor. For example, the Hall sensor may be disposed in the first housing 210 or the second housing 220, and the magnet may be disposed in the first housing 210 or the second housing 220 in which the Hall sensor is not disposed. When the Hall sensor and the magnet are disposed in the first housing 210 and the second housing 220, which move relative to each other, respectively, the strength of a magnetic field recognized by the Hall sensor may vary depending on the relative distance between the magnet and the Hall sensor, and this may be used to sense the folded or unfolded state of the first housing 210 and the second housing 220. The fourth shielding member 540 may be disposed between the display module 230 and at least one of the Hall sensor and the magnet of the sensor member to shield a magnetic field generated by the sensor member.

According to an embodiment, the waterproof members 481, 482, 483, and 484 may be disposed between the display module 230 and the housing to isolate the display module 230 and electrical components connected to the display module 230 from external moisture.

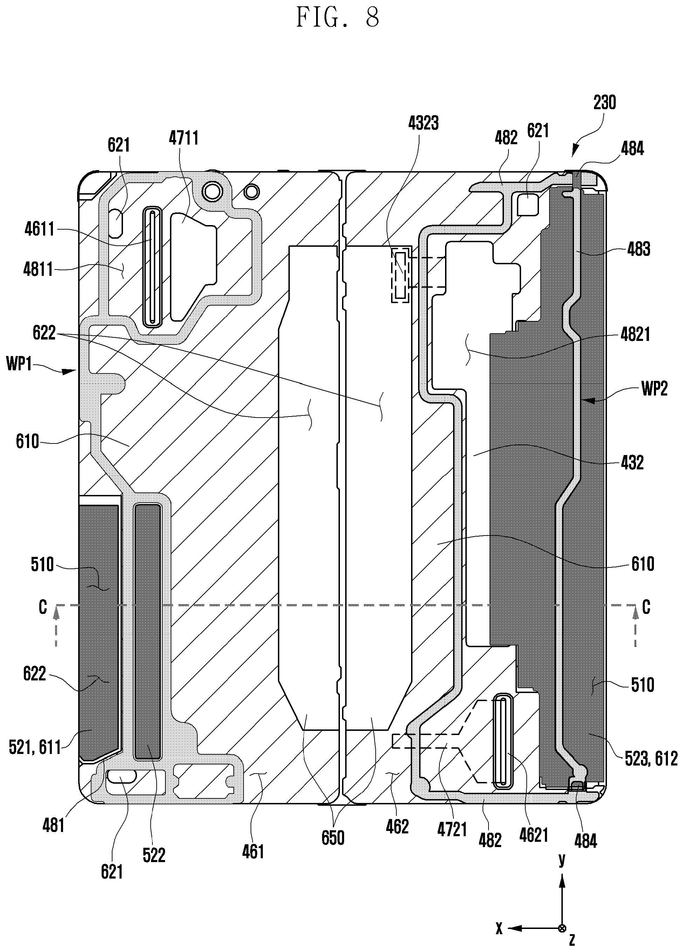

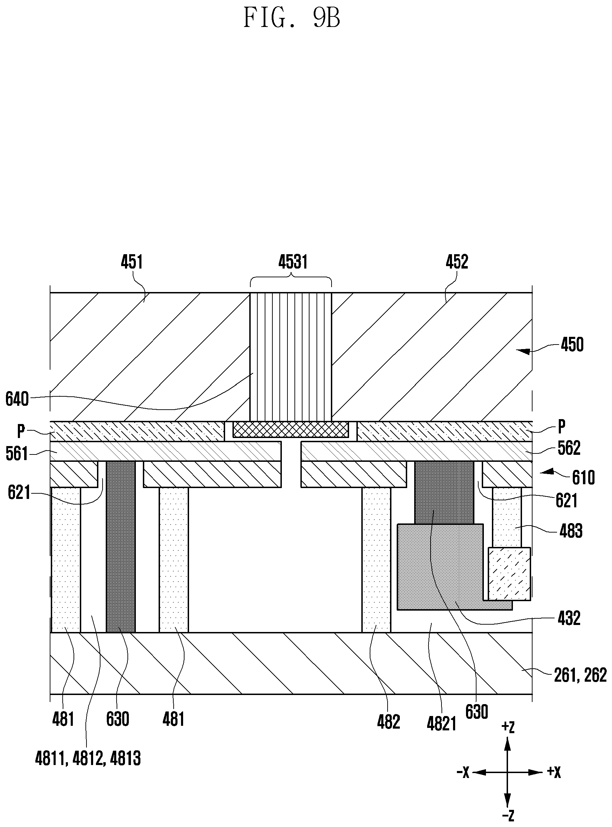

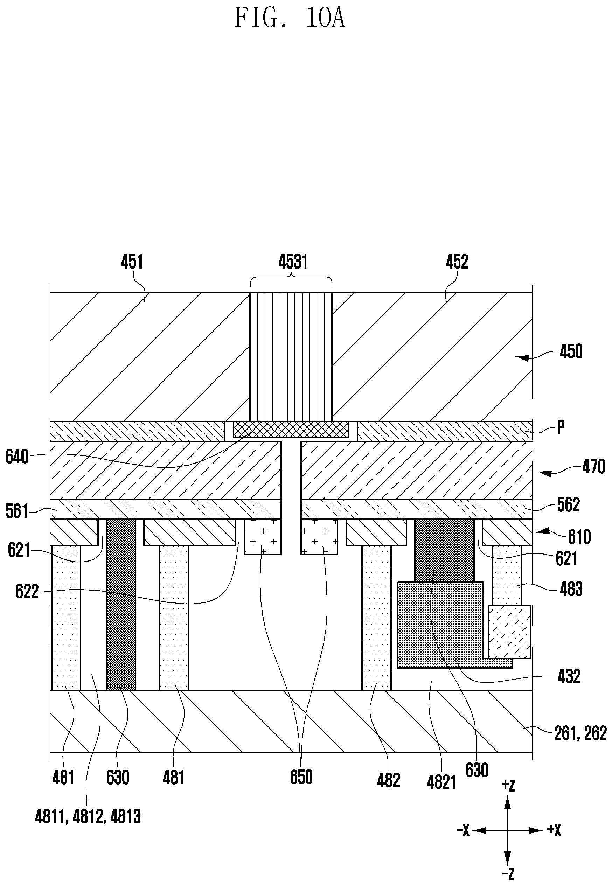

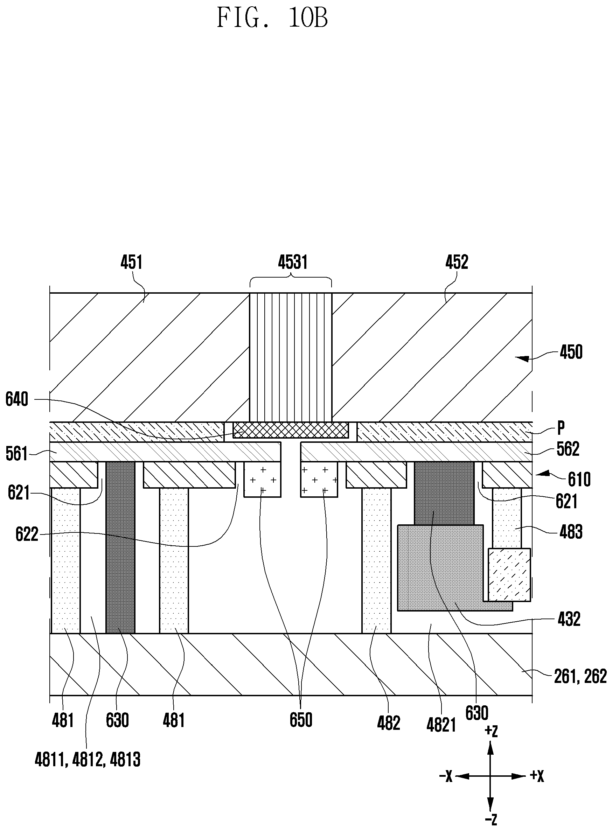

FIG. 8 illustrates a state in which a protective layer is disposed on the rear surface of the display module in FIG. 6 according to an embodiment of the disclosure. FIG. 9A is a schematic diagram of a cross-section of the display module illustrated in FIG. 8 according to an embodiment of the disclosure and cut along line C-C. FIG. 9B is a cross -sectional diagram of the display module illustrated in FIG. 8 according to an embodiment of the disclosure without a digitizer panel. FIG. 10A illustrates a cross-sectional diagram in which a non-conductive member is disposed in a second opening of a protective layer illustrated in FIG. 9A according to an embodiment of the disclosure. FIG. 10B illustrates a cross-sectional diagram of the display module illustrated in FIG. 9A according to an embodiment of the disclosure without a digitizer panel.

According to an embodiment, as illustrated in FIG. 8, a protective layer 610 may be disposed on rear surfaces of reinforced plates 561 and 562 (e.g., the reinforced plates 461 and 462 in FIG. 4). Prior to the description of the protective layer 610, the support plate 450, the digitizer panel 470, and the reinforced plates 561 and 562 will be briefly described.

According to an embodiment, the reinforced plates 561 and 562 may be disposed under the support plate 450 to provide rigidity to the display module 230, and may be used as grounds for preventing malfunction of the display module 230. In addition, the reinforced plates 561 and 562 may be used as heat dissipation paths for heat generated inside the electronic device 200.

According to an embodiment, as illustrated in FIG. 9A, the digitizer panel 470 that exchanges signals with an electronic pen may be disposed in the electronic device 200. The digitizer panel 470 may be disposed under the support plate 450 (e.g., in the -z direction in FIG. 9A). Since the electronic pen generating an electrical signal in proximity to the digitizer panel 470 approaches or contacts the surface of the display module 230, the support plate 450 may be disposed between the electronic pen and the digitizer panel 470. When the support plate 450 includes a metal material such as SUS or CLAD, electromagnetic signals between the digitizer panel 470 and the electronic pen may be blocked by the support plate 450. Therefore, when the digitizer panel 470 is disposed under the support plate 450, the support plate 450 may be formed of a dielectric such as carbon fiber reinforced plastics (CFRP) so that signals between the digitizer panel 470 and the electronic pen are not blocked. The dielectric may be a non-metal insulating material that is polarized in an electric field (e-field). For example, the dielectric may be polarized through an electric field generated from an electronic component inside the electronic device 200.

According to an embodiment, as described above, when the digitizer panel 470 is disposed under the support plate 450, a plate formed of a metal material (e.g., Cu or Al) may be disposed beneath the digitizer panel 470 so that noise and heat generated by the digitizer panel 470 can be discharged. For example, the digitizer panel 470 may discharge noise and heat through the reinforced plates 561 and 562 disposed under the digitizer panel 470.

According to an embodiment, as illustrated in FIG. 9A, when the digitizer panel 470 is disposed between the support plate 450 and the reinforced plates 561 and 562, the reinforced plates 561 and 562 may be formed of a material having high electrical and thermal conductivity so that noise and heat generated by the digitizer panel 470 can be discharged to the surroundings. For example, the reinforced plates 561 and 562 may be formed of at least one of stainless use steel (SUS), copper (Cu), and aluminum (Al). In addition, the reinforced plates 561 and 562 may be formed of various materials having high electrical and thermal conductivity.

According to an embodiment, FIG. 9B shows a stacked structure of various materials constituting the support plate 450 when the digitizer panel 470 is not disposed inside the electronic device 200. When the digitizer panel 470 is not placed under the support plate 450, the support plate 450 may include a metal material (e.g., SUS or CLAP) to improve durability of the display module 230. In this case, a plate formed of a metal material may be disposed under the support plate 450 so that noise and heat generated by the display module 230 can be discharged. For example, as the reinforced plates 561 and 562 formed of a metal material (e.g., SUS, Cu, or Al) having high electrical and thermal conductivity are disposed under the support plate 450, noise and heat generated by the display module 230 can be discharged to the surroundings. However, the material of the above-described reinforced plates 561 and 562 is only an example, and the reinforced plates may be formed of various materials having high electrical and thermal conductivity.

According to an embodiment, the reinforced plates 561 and 562 illustrated in FIGS. 9A, 9B, 10A, and 10B may have a thickness (a length in the Z-axis direction in FIG. 9A) smaller than thickness of the reinforced plates 461 and 462 illustrated in FIG. 6 (e.g., based on FIG. 9A). When the thickness of the reinforced plates 561 and 562 becomes smaller, damage may occur to the reinforced plates 561 and 562 during external impact or processing of the display module 230. In addition, in some embodiments, the reinforced plates 561 and 562 may be formed of a material such as Cu or Al, which has a lower unit weight and higher thermal conductivity and electrical conductivity than SUS. When the reinforced plates 561 and 562 are formed of a material such as Cu or Al rather than SUS, corrosion resistance may be weakened compared with the case where the reinforced plates are formed of SUS. According to the present invention, the protective layer 610 formed of an insulating material is disposed on the rear surfaces of the reinforced plates 561 and 562 (e.g., the surface facing the -Z direction in FIG. 9A). The protective layer 610 may improve the durability and corrosion resistance of the reinforced plates 561 and 562. The protective layer 610 will be described in detail below.

According to an embodiment, as illustrated in FIGS. 8 and 9A to 10B, the protective layer 610 may be disposed on each of the rear surfaces of the reinforced plates 561 and 562. The protective layer 610 may be disposed (or attached) to the rear surface (e.g., the surface facing the Z direction in FIG. 9A) of each of the reinforced plates 561 and 562 to correspond to the reinforced plates 561 and 562. The protective layer 610 may block moisture introduced into the electronic device 200 from being brought into contact with the reinforced plates 561 and 562, which may be formed of a metal material. Accordingly, corrosion of the reinforced plates 561 and 562 due to liquid introduced into the electronic device 200 may be alleviated or mitigated by the protective layer 610. In addition, the protective layer 610 may block moisture introduced into the electronic device 200 from entering the digitizer panel 470 or a component (e.g., the display panel 430) constituting the display module 230.

According to an embodiment, the durability of the reinforced plates 561 and 562 may be improved by disposing the protective layer 610 on each of the rear surfaces of the reinforced plates 561 and 562. In an embodiment, the protective layer 610 may include an adhesive. The protective layer 610 may be directly attached to the reinforced plates 561 and 562 by the adhesive. In some embodiments, the protective layer 610 may be brought into close contact with the reinforced plates 561 and 562 through an adhesive P. The reinforced plates 561 and 562 may be coupled to the protective layer 610 through the adhesive P, and thus when an external impact is applied to the display module 230, durability may be improved compared with the case in which there is no protective layer 610. In addition, in an embodiment, holes or openings may be formed in the reinforced plates 561 and 562 during processing of the display module 230. Since processing for forming holes or openings in the reinforced plates 561 and 562 is performed while the protective layer 610 is attached to the reinforced plates 561 and 562, damage to the reinforced plates 561 and 562 during the processing process may be alleviated compared with the case of directly processing the reinforced plates 561 and 562 without the protective layer 610.

According to an embodiment, as illustrated in FIGS. 8 and 9A to 10B, the protective layer 610 may include multiple openings 621 and 622. In an embodiment, the protective layer 610 may include a first opening 621 and a second opening 622. At least part of the multiple openings 621 and 622 may be positioned in the waterproof spaces 4811, 4812, 4813, and 4821 formed by the waterproof members 481, 482, 483, and 484. The multiple openings 621 and 622 may be distinguished according to whether the multiple openings 621 and 622 are positioned inside the waterproof spaces 4811, 4812, 4813, and 4821 of the waterproof members 481, 482, 483, and 484. For example, as will be described later, the first opening 621 among the multiple openings 621 and 622 may be positioned inside the waterproof spaces 4811, 4812, 4813, and 4821 formed by the waterproof members 481, 482, 483, and 484. One surface of each of the reinforced plates 561 and 562 is exposed through the first opening 621 positioned in the waterproof space 4811, 4812, 4813, and 4821 to be electrically connected to an electrical object. Therefore, the electrical objects electrically connected to the reinforced plates 561 and 562 may be positioned in the waterproof space 4811, 4812, 4813, and 4821, and thus protected from external liquids or foreign matter. The second opening 622, among the multiple openings 621 and 622, may be positioned outside the waterproof spaces 4811, 4812, 4813, and 4821. In an embodiment, the second opening 622 may expose one surface of each of the reinforced plates 561 and 562 outside the waterproof spaces 4811, 4812, 4813, and 4821. In some embodiments, the second opening 622 may be formed at a position corresponding to an area, in which the reinforced plates 561 and 562 are removed, outside the waterproof spaces 4811, 4812, 4813, and 4821. In an embodiment, instruments formed of a non-conductive material and disposed in the electronic device 200 may be brought into contact with the reinforced plates 561 and 562 through the second opening 622.

According to an embodiment, as illustrated in FIGS. 8 and 9A to 10B, at least one surface of each of the reinforced plates 561 and 562 may be exposed through the first opening 621. The reinforced plates 561 and 562 may be electrically connected to an electrical object through the first opening 621. In an embodiment, the reinforced plates 561 and 562 may be connected to electrical objects through the first opening 621. One surface of each of the reinforced plates 561 and 562 may be exposed through the first opening 621, and may be electrically connected to an electric object through the first opening 621. In an embodiment, the reinforced plates 561 and 562 may be electrically connected to a ground through the first opening 621. In some embodiments, the reinforced plates 561 and 562 may be electrically connected to a fingerprint recognition sensor (not shown) or the bending portion 432 of the display module 230 through the first opening 621. In addition, the reinforced plates 561 and 562 may be electrically connected to various electrical objects through the first opening 621.

According to an embodiment, the reinforced plates 561 and 562 may include areas in which the reinforced plates 561 and 562 are at least partially removed. In an embodiment, in relation to the areas in which the reinforced plates 561 and 562 are removed, areas facing the magnet member 710 may be removed. For example, the reinforced plates 561 and 562 may be partially removed in a side area or a corner of the electronic device 200 in which the magnet member 710 is disposed. Areas to be removed from the reinforced plates 561 and 562 may be areas magnetized by the magnet member 710 or an electronic component disposed inside the electronic device 200. When one area (e.g., the second area) of the reinforced plates 561 and 562 is removed, a phenomenon in which the display module 230 or the digitizer panel 470 malfunctions may be alleviated, mitigated or avoided.

According to an embodiment, as illustrated in FIG. 8, the second opening 622 may be positioned in an area where the reinforced plates 561 and 562 are not in contact with electrical objects. In an embodiment, referring to FIG. 8 , the second opening 622 may be positioned in a center portion of the display module 230 corresponding to the folding area 230c (or the bending portion 453 of the display module 230) or in a side area of the display module 230. In an embodiment, instruments formed of a non-conductive material may be disposed in the second opening 622. In an embodiment, the second opening 622 may be positioned to correspond to areas of the reinforced plates 561 and 562 in which the reinforced plates 561 and 562 are at least partially removed. For example, the second opening 622 of the protective layer 610 may be positioned to correspond to the areas, in which the reinforced plates 561 and 562 have been removed, so that the magnet member 710 disposed in the areas in which the reinforced plates 561 and 562 have been removed, can be exposed. However, this is only an example, and various components disposed inside the electronic device 200 may be disposed.

According to an embodiment, as illustrated in FIG. 8, the second opening 622 of the protective layer 610 may be formed such that one surface of each of the reinforced plates 561 and 562 is exposed. As described above, instruments formed of non-conductive materials may be disposed in the second opening 622. For example, referring to FIGS. 9, 10A, and 10B , an instrument formed of a non-conductive material, such as the cushion layer 650 for cushioning an external impact applied to the display module 230, may be positioned in the second opening 622. The cushion layer 650 may be disposed in the second opening 622 positioned at the center portion of the display module 230 to cushion an external impact applied to the folding area 230c of the display module 230. In addition, various instruments may be arranged on one surface of each of the reinforced plates 561 and 562, exposed through the second opening 622. For example, instruments formed of a non-conductive material may be disposed on the reinforced plates 561 and 562 through the second opening 622. In some embodiments, instruments formed of a conductive material may be disposed on the reinforced plates 561 and 562.

According to an embodiment, the waterproof members 481, 482, 483, and 484 may be disposed on the rear surface (e.g., the surface facing the -Z direction in FIG. 9A) of the protective layer 610. In an embodiment, the waterproof members 481, 482, 483, and 484 may be disposed on the rear surface of the protective layer 610 such that an opening (e.g., the first opening 621) in which an electrical object is disposed is positioned in the waterproof space 4811, 4812, 4813, and 4821. For example, the first opening 621 of the protective layer 610, in which the electrical object is disposed, may be positioned in the waterproof spaces 4811, 4812, 4813, and 4821 formed by the waterproof members 481, 482, 483, and 484. On the other hand, the second opening 622 of the protective layer 610, in which no electrical object is disposed, may be positioned outside the waterproof spaces 4811, 4812, 4813, and 4821. Therefore, one surface of each of the reinforced plates 561 and 562, exposed through the first opening 621, may be protected from an external liquid introduced into the electronic device 200.

According to an embodiment, as illustrated in FIGS. 9A to 10B, the reinforced plates 561 and 562 may be electrically connected to various electrical objects through a conductive member 630 disposed in the first opening 621. In an embodiment, the conductive member 630 may be formed of a material having high electrical conductivity, such as Cu or Al. In an embodiment, the conductive member 630 may be coupled to the reinforced plates 561 and 562 and electrical objects in various ways. For example, the conductive member 630 may be coupled to the reinforced plates 561 and 562 and the electrical objects in various ways such as socket coupling, clip coupling (e.g., c-clip), and soldering.

In an embodiment, the reinforced plates 561 and 562 may be electrically connected to a ground through the conductive member 630. For example, the reinforced plates 561 and 562 may be electrically connected to grounds disposed in the support members 261 and 262 or a ground disposed in the display module 230 through the conductive member 630. In addition, the reinforced plates 561 and 562 may be electrically connected, through the conductive member 630, to electronic components (e.g., sensor modules) disposed in the electronic device 200.

According to an embodiment, as illustrated in FIGS. 10A and 10B, instruments disposed inside the electronic device 200 may be disposed inside the second opening 622 among the multiple openings 621 and 622. In an embodiment, referring to FIGS. 10A and 10B, the cushion layer 650 may be disposed in the second opening 622 of the protective layer 610, positioned in the folding area 230c. At least a portion of the cushion layer 650 may be disposed in the second opening 622 positioned in the folding area 230c of the display module 230. The cushion layer 650 may be formed of a material capable of cushioning an external impact applied to the display module 230. The cushion layer 650 may include a porous foam material (e.g., a sponge) so as to be deformed by an external force and cushion an impact. In addition, the cushion layer 650 may include various materials capable of cushioning an external force.

In an embodiment, when instrument(s) in the electronic device 200 are stacked on the protective layer 610, the thickness of the electronic device 200 increases in the Z-axis direction, whereby sealing through the waterproof structures WP1 and WP2 may not be performed smoothly, and the surface quality of the display module 230 may deteriorate. According to an embodiment of the disclosure, as described above, the protective layer 610 may include the second opening 622. The second opening 622 may be positioned outside the waterproof spaces 4811, 4812, 4813, and 4821. Instruments disposed in the electronic device 200 may be disposed in the second opening 622. For example, instruments formed of a non-conductive material, such as the magnet member 710 and the cushion layer 650 positioned in the folding area of the display module 230, may be disposed in the second opening 622. Various other instruments may be disposed in the second opening 622. When an instrument is disposed in the second opening 622, the increase in the thickness of the electronic device 200 in the Z-axis direction may be small compared with when the instrument is disposed on the protective layer 610. Therefore, sealing through the waterproof structures WP1 and WP2 may be smoothly performed, and the surface quality of the display module 230 may be improved.

According to an embodiment of the disclosure, the reinforced plates 561 and 562 illustrated in FIGS. 9A to 10B may have a thickness (e.g., a length in the Z-axis direction in FIG. 9A) smaller than the thickness of the reinforced plates 461 and 462 illustrated in FIG. 4. Also, in an embodiment, the reinforced plates 561 and 562 may be formed of a metal material such as Cu or Al having a relatively light unit weight. Accordingly, the weight of the reinforced plates 461 and 462 may be reduced as the thickness and unit weight thereof decrease. In an embodiment, as described above, the protective layer 610 may be disposed on the rear surfaces of the reinforced plates 561 and 562. The protective layer 610 may be in close contact with the reinforced plates 561 and 562 to correspond to the reinforced plates 561 and 562. When the protective layer 610 is in close contact with the rear surfaces of the reinforced plates 561 and 562 through the adhesive P, the durability of the reinforced plates 561 and 562 against external impact may be improved. In addition, the reinforced plates 561 and 562 may be protected from an external liquid, introduced into the electronic device 200, by the protective layer 610. Accordingly, the corrosion resistance of the reinforced plates 561 and 562 may be improved. Meanwhile, the protective layer 610 may include the first opening 621 and the second opening 622. The reinforced plates 561 and 562 may be brought into contact with electrical objects through the first opening 621. For example, one surface of each of the reinforced plates 561 and 562 may be exposed through the first opening 621, and thus the reinforced plates 561 and 562 may be electrically connected to an electrical object (e.g., a ground, a fingerprint recognition sensor, or the display module 230). In some embodiments, the reinforced plates 561 and 562 may be electrically connected to the display panel 430 or the digitizer panel 470 through a conductive film (ACF) disposed in the first opening 621. The waterproof members 481, 482, 483, and 484 may be disposed on the rear surface of the protective layer 610 such that the first opening 621 is positioned in the waterproof spaces 4811, 4812, 4813, and 4821. Accordingly, the reinforced plates 561 and 562 exposed through the first opening 621 may be protected from an external liquid. Instruments other than an electrical object may be disposed in the second opening 622. The thickness of the protective layer 610 may be reduced in the Z-axis direction by the second opening 622. Therefore, even when an instrument is disposed in the second opening 622, sealing through the waterproof structures WP1 and WP2 may be smoothly performed, and the surface quality of the display module 230 may be improved.

According to an embodiment of the disclosure, elements constituting the display module 230 may be in close contact with each other so that an air gap is not formed. For example, the window layer 410, the polarizer 420, the display panel 430, the polymer layer 440, the support plate 450, the digitizer panel 470, the reinforced plates 561 and 562, and the waterproof members 481, 482, 483, and 484 may be in close contact with each other. In this case, even when an impact is transmitted to the display module 230, the elements are in close contact with each other, and thus the cushioning effect may be improved compared with the case where an air gap is formed between each of the elements.

In the above description, it has been described on the premise that the electronic device is a foldable electronic device. For example, the aforementioned electronic device may include a foldable flexible display 230 as an electronic device having a first housing 210 and a second housing 220 rotatably coupled to the first housing 210. there is. However, it may not be limited to these embodiments. In one embodiment, the electronic device may include a bar type electronic device composed of one housing. For example, many of the features disclosed in relation to a pair of stiffening plates may be applied to an electronic device that includes only one of the pair of stiffening plates. Accordingly, the present invention should not be viewed as being limited to foldable displays and/or foldable electronic devices. Accordingly, embodiments of the present invention may include an electronic device and/or a bar type electronic device implementing a flat (eg, rigid) display.

According to an embodiment of the disclosure, an electronic device 200 may include a first housing 210, a second housing 220 rotatably connected to the first housing, and a display module 230 (e.g., the first display 230) including a folding area 230c at least partially deformed by rotation of the second housing relative to the first housing, wherein the display module includes a display panel 430, a support plate 450 disposed under the display panel to support the display panel, a reinforced plate 561 or 562 (e.g., the reinforced plates 461 and 462 in FIG. 4) disposed under the support plate, a protective layer 610 disposed under the reinforced plate and including multiple openings 621 and 622, and a waterproof member 481, 482, 483, or 484 disposed under the protective layer to have a waterproof space 4811, 4812, 4813, or 4821 including at least one of the multiple openings.

In addition, the protective layer may include a first opening 621 positioned in the waterproof space of the waterproof member and a second opening 622 positioned outside the waterproof space of the waterproof member, and the reinforced plate may be electrically connected, through the first opening, to an electric object disposed inside the electronic device.

In addition, the reinforced plate may be electrically connected to a ground of the electronic device through the first opening.

In addition, the electronic device may further include a conductive member 630 disposed in the first opening to electrically connect the reinforced plate to the electrical object of the electronic device.

In addition, an instrument formed of a non-conductive material may be disposed in the second opening.

In addition, the second opening may be formed at a position corresponding to the folding area of the display module and a position adjacent to a side surface of the electronic device.

In addition, at least one of a magnet member 710 and a cushion layer 650 may be disposed in the second opening.

In addition, the reinforced plate may be formed of a metal material.

In addition, the reinforced plate may be formed of at least one of Cu, Al, and SUS.

In addition, the electronic device may further include a digitizer panel 470 disposed between the support plate and the reinforced plate.

In addition, the support plate may include multiple patterns 4531 (e.g., multiple openings 4531)positioned in the folding area of the display module.

According to an embodiment of the disclosure, a display module 230 disposed in a first housing 210 and a second housing 220 rotatably coupled to each other may include a display panel 430, a support plate 450 disposed under the display panel to support the display panel and including multiple patterns 4531 positioned in a folding area of the display module, a reinforced plate 561 or 562 (e.g., the reinforced plates 461 and 462 in FIG. 4) disposed under the support plate, a protective layer disposed under the reinforced plate and including multiple openings 621 and 622, and a waterproof member 481, 482, 483, or 484 disposed under the protective layer to have a waterproof space 4811, 4812, 4813, or 4821 including at least one of the multiple openings.

In addition, the protective layer may include a first opening 621 positioned in the waterproof space of the waterproof member and a second opening 622 positioned outside the waterproof space of the waterproof member, and the reinforced plate may be electrically connected to an electric object through the first opening.

In addition, the reinforced plate may be electrically connected to a ground through the first opening.

In addition, the display module may further include a conductive member 630 disposed in the first opening to electrically connect the reinforced plate to the electrical object.

In addition, an instrument formed of a non-conductive material may be disposed in the second opening.

In addition, the second opening may be formed at a position corresponding to the folding area of the display module and a position adjacent to a side surface of the display module.

In addition, the reinforced plate may be formed of a metal material.

In addition, the reinforced plate may be formed of at least one of Cu, Al, and SUS.

In addition, the display module may further include a digitizer panel 470 disposed between the support plate and the reinforced plate.

According to an embodiment of the disclosure, the weight of the reinforced plate 561 or 562 supporting the display panel 430 may be reduced by changing the thickness and/or the material of the reinforced plate. Meanwhile, the durability and corrosion resistance of the reinforced plate may be improved by disposing the protective layer (e.g., an insulating layer) 610 on the reinforced plate.

It will be appreciated that, in addition to the embodiments disclosed above, the present disclosure also considers, and includes, embodiments based on a combination of any two or more of the embodiments disclosed above, and embodiments comprising any combination of the features disclosed herein. That is, the lack of an explicit indication that two features may be combined or two embodiments may be combined does not mean such a combination is not envisaged, but instead such a combination should be seen to be included herein.

## Claims

1. A display module (230) comprising:
a display panel (430);
a support plate (450) disposed under the display panel to support the display panel and comprising multiple patterns (4531) positioned in a folding area (230c) of the display module;
a reinforced plate (561 or 562) disposed under the support plate;
a protective layer (610) disposed under the reinforced plate, the protective layer including an insulating material and including a plurality of openings (621 and 622); and
a waterproof member (481, 482, 483, or 484) disposed under the protective layer to have a waterproof space (4811, 4812, 4813, or 4821), and
wherein at least one of the plurality of openings (621 and 622) is disposed in the waterproof space (4811, 4812, 4813, or 4821).

2. The display module of claim 1, wherein the plurality of openings comprises a first opening (621) positioned in the waterproof space of the waterproof member and a second opening (622) positioned outside the waterproof space of the waterproof member, and
the reinforced plate is electrically connected to an electric object through the first opening.

3. The display module of claim 2, wherein the reinforced plate is electrically connected to a ground through the first opening.

4. The display module of claim 2 or claim 3, further comprising a conductive member (630) disposed in the first opening to electrically connect the reinforced plate to the electrical object.

5. The display module of any of claims 2 to 4, wherein an instrument formed of a nonconductive material is disposed in the second opening.

6. The display module of claim 2, wherein the second opening is formed at a position corresponding to the folding area of the display module and a position adj acent to a side surface of the display module.

7. The display module of claim 2, wherein at least one of a magnet member and a cushion layer is disposed in the second opening.

8. The display module of claim 1, further comprising a digitizer panel (470) disposed between the support plate and the reinforced plate.

9. The display module of claim 1, wherein the support plate comprises multiple patterns (4531) positioned in the folding area of the display module

10. An electronic device (200) comprising:
a first housing (210);
a second housing (220) rotatably connected to the first housing;
a hinge device (400, 400-1) connecting the first housing (210) and the second housing (220); and
a display module (230) according to any one of claims 1 to 9, wherein the display module comprises the folding area (230c) at least partially deformed by rotation of the second housing relative to the first housing

## Patentansprüche

1. Anzeigemodul (230), umfassend:
ein Anzeigefeld (430);
eine Stützplatte (450), die unter dem Anzeigefeld angeordnet ist, um das Anzeigefeld zu stützen, und mehrere Muster (4531) umfasst, die in einem Klappbereich (230c) des Anzeigemoduls positioniert sind;
eine verstärkte Platte (561 oder 562), die unter der Stützplatte angeordnet ist;
eine Schutzschicht (610), die unter der verstärkten Platte angeordnet ist, wobei die Schutzschicht ein Isoliermaterial enthält und eine Vielzahl von Öffnungen (621 und 622) enthält; und
ein wasserdichtes Element (481, 482, 483 oder 484), das unter der Schutzschicht angeordnet ist, um einen wasserdichten Raum (4811, 4812, 4813 oder 4821) aufzuweisen, und
wobei mindestens eine aus der Vielzahl von Öffnungen (621 und 622) in dem wasserdichten Raum (4811, 4812, 4813 oder 4821) angeordnet ist.

2. Anzeigemodul nach Anspruch 1, wobei die Vielzahl von Öffnungen eine erste Öffnung (621), die in dem wasserdichten Raum des wasserdichten Elements positioniert ist, und eine zweite Öffnung (622), die außerhalb des wasserdichten Raums des wasserdichten Elements positioniert ist, umfasst und
die verstärkte Platte durch die erste Öffnung elektrisch mit einem elektrischen Objekt verbunden ist.

3. Anzeigemodul nach Anspruch 2, wobei die verstärkte Platte durch die erste Öffnung elektrisch mit einer Masse verbunden ist.

4. Anzeigemodul nach Anspruch 2 oder Anspruch 3, ferner umfassend ein leitendes Element (630), das in der ersten Öffnung angeordnet ist, um die verstärkte Platte elektrisch mit dem elektrischen Objekt zu verbinden.

5. Anzeigemodul nach einem der Ansprüche 2 bis 4, wobei ein Instrument, das aus einem nicht leitenden Material ausgebildet ist, in der zweiten Öffnung angeordnet ist.

6. Anzeigemodul nach Anspruch 2, wobei die zweite Öffnung an einer Position ausgebildet ist, die dem Klappbereich des Anzeigemoduls und einer Position benachbart zu einer Seitenfläche des Anzeigemoduls entspricht.

7. Anzeigemodul nach Anspruch 2, wobei mindestens eines von einem Magnetelement und einer Dämpfungsschicht in der zweiten Öffnung angeordnet ist.

8. Anzeigemodul nach Anspruch 1, ferner umfassend ein Digitalisiererfeld (470), das zwischen der Stützplatte und der verstärkten Platte angeordnet ist.

9. Anzeigemodul nach Anspruch 1, wobei die Stützplatte mehrere Muster (4531) umfasst, die im Klappbereich des Anzeigemoduls positioniert sind.

10. Elektronische Vorrichtung (200), umfassend:
ein erstes Gehäuse (210);
ein zweites Gehäuse (220), das drehbar mit dem ersten Gehäuse verbunden ist;
eine Scharniervorrichtung (400, 400-1), die das erste Gehäuse (210) und das zweite Gehäuse (220) verbindet; und
ein Anzeigemodul (230) nach einem der Ansprüche 1 bis 9, wobei das Anzeigemodul den Klappbereich (230c) umfasst, der durch Drehung des zweiten Gehäuses relativ zu dem ersten Gehäuse mindestens teilweise verformt ist.

## Revendications

1. Module d'affichage (230) comprenant :
un panneau d'affichage (430) ;
une plaque de support (450) disposée sous le panneau d'affichage pour supporter le panneau d'affichage et comprenant de multiples motifs (4531) positionnés dans une zone de pliage (230c) du module d'affichage ;
une plaque renforcée (561 ou 562) disposée sous la plaque de support ;
une couche de protection (610) disposée sous la plaque renforcée, la couche de protection comprenant un matériau isolant et comprenant une pluralité d'ouvertures (621 et 622) ; et
un élément imperméable à l'eau (481, 482, 483 ou 484) disposé sous la couche de protection pour avoir un espace imperméable à l'eau (4811, 4812, 4813 ou 4821), et
dans lequel au moins une de la pluralité d'ouvertures (621 et 622) est disposée dans l'espace imperméable à l'eau (4811, 4812, 4813 ou 4821).

2. Module d'affichage de la revendication 1, dans lequel la pluralité d'ouvertures comprend une première ouverture (621) positionnée dans l'espace imperméable à l'eau de l'élément imperméable à l'eau et une seconde ouverture (622) positionnée à l'extérieur de l'espace imperméable à l'eau de l'élément imperméable à l'eau, et
la plaque renforcée est reliée électriquement à un objet électrique à travers la première ouverture.

3. Module d'affichage de la revendication 2, dans lequel la plaque renforcée est électriquement reliée à une masse à travers la première ouverture.

4. Module d'affichage de la revendication 2 ou de la revendication 3, comprenant en outre un élément conducteur (630) disposé dans la première ouverture pour relier électriquement la plaque renforcée à l'objet électrique.

5. Module d'affichage de l'une quelconque des revendications 2 à 4, dans lequel un instrument formé d'un matériau non conducteur est disposé dans la seconde ouverture.

6. Module d'affichage de la revendication 2, dans lequel la seconde ouverture est formée à une position correspondant à la zone de pliage du module d'affichage et à une position adjacente à une surface latérale du module d'affichage.

7. Module d'affichage de la revendication 2, dans lequel au moins l'un d'un élément magnétique et d'une couche de coussin est disposé dans la seconde ouverture.

8. Module d'affichage de la revendication 1, comprenant en outre un panneau numériseur (470) disposé entre la plaque de support et la plaque renforcée.

9. Module d'affichage de la revendication 1, dans lequel la plaque de support comprend de multiples motifs (4531) positionnés dans la zone de pliage du module d'affichage.

10. Dispositif électronique (200) comprenant :
un premier boîtier (210) ;
un second boîtier (220) relié de manière rotative au premier boîtier ;
un dispositif de charnière (400, 400-1) reliant le premier boîtier (210) et le second boîtier (220) ; et
un module d'affichage (230) selon l'une quelconque des revendications 1 à 9, dans lequel le module d'affichage comprend la zone de pliage (230c) au moins partiellement déformée par rotation du second boîtier par rapport au premier boîtier.
